(19) Europäisches Patentamt
European Patent Office
Office européen des brevets

(11) EP 1 174 891 A2

(12) # EUROPEAN PATENT APPLICATION

(43) Date of publication:
23.01.2002 Bulletin 2002/04

(51) Int Cl.$^7$: H01G 9/20

(21) Application number: 01117297.0

(22) Date of filing: 17.07.2001

(84) Designated Contracting States:
AT BE CH CY DE DK ES FI FR GB GR IE IT LI LU MC NL PT SE TR
Designated Extension States:
AL LT LV MK RO SI

(30) Priority: 19.07.2000 JP 2000218660
21.07.2000 JP 2000220470

(71) Applicant: FUJI PHOTO FILM CO., LTD.
Kanagawa-ken (JP)

(72) Inventors:
- Wariishi, Koji
  Minami-Ashigara-shi, Kanagawa (JP)
- Watanabe, Tetsuya
  Minami-Ashigara-shi, Kanagawa (JP)

(74) Representative: Patentanwälte Dr. Solf & Zapf
Candidplatz 15
81543 München (DE)

(54) **Dye sensitized photoelectrochemical cell**

(57) The present invention provides a semiconductor for photoelectric conversion which exhibits a high open circuit voltage, as well as a photoelectric converting device which is excellent in photoelectric conversion characteristics and a photocell. In the semiconductor for photoelectric conversion, a compound is bonded at least to a surface of a semiconductor, and a dye is fixed to the compound bonded to the semiconductor through an interaction between an acidic group or an anionic group, formed by removing a proton from an acidic group, and a basic group and/or a group having a cationic group. The photoelectric converting device and the photocell include the semiconductor for photoelectric conversion.

FIG. 5

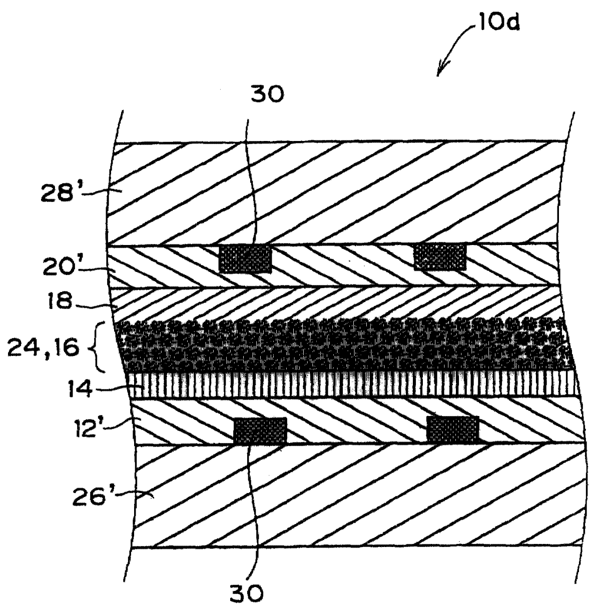


EP 1 174 891 A2

## Description

BACKGROUND OF THE INVENTION

Field of the Invention:

The present invention relates to a semiconductor for photoelectric conversion and a photoelectric converting device using the same which is excellent in photoelectric conversion characteristics, as well as to a photocell comprising the photoelectric converting device.

Description of the Related Art:

Solar cells used for solar-light power generation, such as a single-crystalline silicon solar cell, a polycrystalline silicon solar cell, an amorphous silicon solar cell, a compound solar cell such as cadmium telluride, indium copper selenide, or the like, are being put into practical use or becoming objects of major researches and developments. However, the compound solar cell has problems such as high production costs, difficulty in procurement of raw materials, long energy pay-back time, and the like, and therefore these problems have to be overcome for the compound solar cell to be widely used. While, many solar cells using organic materials, which are directed to have large areas and to be produced at low costs, have also been proposed.

In the situation like this, a photoelectric converting device using dye-sensitized semiconductor particles, and a solar cell, as well as materials and a production technique thereof have been disclosed in "Nature" (Vol. 353, pp. 737-740, 1991), US Patent No. 4,927,721, and the like. The cell disclosed in these literature and the like is a wet type solar cell wherein a porous titanium dioxide thin film spectrally sensitized with a ruthenium complex works as a working electrode, which is electrically connected to a counter electrode via an electrolytic solution. The merit of this solar cell is that it can be produced using inexpensive oxide semiconductors such as titanium dioxide without highly purifying them, and is advantageous in terms of accomplishing inexpensive photoelectric converting devices. However, it has a problem of low conversion efficiency. One of the major causes of this problem is that an actually obtained open circuit voltage (Voc) is significantly lower than a theoretically expected Voc. For example, when titanium dioxide is used for semiconductor particles and ($I^-/I_3^-$ system) is used for an electrolyte, theoretically an open circuit voltage of at least 1V is expected, however, actually a low open circuit voltage of only about 0.6V is obtained.

SUMMARY OF THE INVENTION

In view of the aforementioned, objects of the present invention are to provide a semiconductor for photoelectric conversion which exhibits a high open circuit voltage, as well as a photoelectric converting device which is excellent in photoelectric conversion characteristics and a photo cell.

Aspects of the present invention for accomplishing the above-described objects are as follows.

The first aspect of the present invention is a semiconductor for photoelectric conversion, the semiconductor comprising;

a compound bonded to the semiconductor at least at a surface of the semiconductor; and
a dye, which is fixed to the compound bonded to the semiconductor by one of interaction between a basic group and an acidic group and interaction between a cationic group and an anionic group formed by proton-dissociation of an acidic group.

The second aspect of the present invention is a semiconductor for photoelectric conversion, the semiconductor comprising;

a compound bonded to the semiconductor at least at a surface of the semiconductor, the compound containing one of an acidic group and an anionic group formed by proton-dissociation of an acidic group; and
a dye, which is fixed to the compound bonded to the semiconductor to mordant the semiconductor, the dye containing at least one of basic group and a cationic group.

The third aspect of the present invention is a semiconductor for photoelectric conversion, the semiconductor comprising:

a structure represented by the following general formula (2) which is present at least at a surface of the semiconductor; and

a dye which is fixed to the structure to mordant the semiconductor, the dye containing at least one of a basic group and a cationic group:

General Formula (2)

$$(P_{SC}-O)_{n}-A-Y^{1}-B$$

wherein, $P_{sc}$ is a semiconductor, O is an oxygen atom, A is a carbonyl group, phosphonyl group, sulfonyl group, silyl group, or borane; n is 1 if A is a carbonyl group or sulfonyl group, n is 2 if A is a phosphonyl group or borane, and n is 3 if A is a silyl group; $Y^1$ is a divalent group; and B is one of a carboxylic group, sulfonic group, phosphonic group, phosphoric group, silicic group, boric group, hydroxyl group, and respective hydrogen-dissociated forms thereof.

The fourth aspect of the present invention is a semiconductor for photoelectric conversion, the semiconductor comprising:

a compound bonded to the semiconductor at least at a surface of the semiconductor, the compound being one of a basic compound and a cationic compound; and
a dye having an acidic group or an anionic group formed by proton-dissociation of an acidic group is made to interact with the compound bonded to the surface to mordant the semiconductor.

The fifth aspect of the present invention is A semiconductor for photoelectric conversion, the semiconductor comprising:

a structure represented by at least one of the following general formula (13), (14) which is present at least at a surface of the semiconductor; and
a dye which is made to interact with the structure to mordant the semiconductor, the dye comprising at least one of an acidic group and an anionic group formed by proton-dissociation of an acidic group:

General Formula (13)

$$\left[ (P_{sc}-O)_{n1}-M^{1}-(B^{1})_{p1} \right]_{m1}-Z^{1}$$

General Formula (14)

$$\left[ (P_{sc}-O)_{n2}-M^{2}-(B^{2})_{p2} \right]_{m2}-Z^{2}\cdot(A)_{q}$$

wherein, $P_{sc}$ is a semiconductor; O is an oxygen atom; $Z^1$ is a basic substituent having a conjugate acid's pKa from 3 to 20; $Z^2$ is an atomic group having a cation; each of $B^1$ and $B^2$ is a divalent bonding group; each of $p^1$ and $p^2$ is 0 or 1; if $p^1$ is 0, $Z^1$ is directly bonded to $M^1$, and if $p^2$ is 0, $Z^2$ is directly bonded to $M^2$; each of $M^1$ and $M^2$ is Si, Ti, Al, Ge or Sn; each of $m^1$ and $m^2$ is an integer from 1 to 3; if $m^1$ is 2 or 3, one combination of $B^1$, $M^1$ and $n^1$ may be the same as and may be different from another combination thereof; if $m^2$ is 2 or 3, one combination of $B^2$, $M^2$ and $n^2$ may be the same as and may be different from another combination thereof; A is an anion; and q is a number such that a cationic charge of $Z^2$ and a total of anionic charge of every A are equal.

In the semiconductor for photoelectric conversion of the present invention, when light is irradiated, the dye fixed by mordanting to the surface of the semiconductor absorbs light and generates electrons and holes. While, the semiconductor receives the electrons (or holes) and transmits them. By sandwiching the semiconductor for photoelectric conversion and a charge transfer layer between a pair of electrodes, and connecting the electrode to an external

load, the electrons or holes collected to one of the electrode by the semiconductor do a work and move from the one electrode to the counter electrode. In the semiconductor for photoelectric conversion of the present invention, by fixing the sensitizing dye to the surface of the semiconductor by mordanting using an electrostatic interaction, a high sensitization efficiency is obtained. Consequently, a photoelectric converting device having the semiconductor for photoelectric conversion described above as a photosensitive layer and a photocell including the photoelectric converting device have a high open circuit voltage.

BRIEF DESCRIPTION OF THE DRAWINGS

Fig. 1 is a partial sectional view showing a structure of a preferable photoelectric converting device of the present invention.
Fig. 2 is a partial sectional view showing a structure of a preferable photoelectric converting device of the present invention.
Fig. 3 is a partial sectional view showing a structure of a preferable photoelectric converting device of the present invention.
Fig. 4 is a partial sectional view showing a structure of a preferable photoelectric converting device of the present invention.
Fig. 5 is a partial sectional view showing a structure of a preferable photoelectric converting device of the present invention.
Fig. 6 is a partial sectional view showing a structure of a preferable photoelectric converting device of the present invention.
Fig. 7 is a partial sectional view showing a structure of a preferable photoelectric converting device of the present invention.
Fig. 8 is a partial sectional view showing a structure of a preferable photoelectric converting device of the present invention.
Fig. 9 is a partial sectional view showing a structure of a preferable photoelectric converting device of the present invention,

DESCRIPTION OF THE PREFERRED EMBODIMENTS

Hereinafter, a semiconductor for photoelectric conversion, a photoelectric converting device, and a photocell of the present invention are respectively described.

[Semiconductor for Photoelectric Conversion]

A semiconductor for photoelectric conversion of the present invention is produced by bonding, to at least a surface of the semiconductor, a compound having an acidic group or an anionic group formed by proton-dissociation of an acidic group (hereinafter referred to as "NEG(-) group"), and making a dye having a basic group and/or a cationic group (hereinafter referred to as "POS(+) group") interact with the compound bonded to the surface to mordant the semiconductor. Further, another semiconductor for photoelectric conversion of the present invention is produced by bonding a compound having a POS(+) group to at least a surface of the semiconductor, and making a dye having a NEG(-) group interact with the compound bonded to the surface to mordant the semiconductor.

(A) Semiconductor

A shape and a structure of the semiconductor are not particularly limited, and the semiconductor may be in a form of a semiconductor substrate consisting of semiconductor materials only, or may be in a form of a semiconductor layer formed, for example, on a transparent electrode such as ITO glass or a conductive support such as a platinum electrode. When the semiconductor is used in the semiconductor layer form, the semiconductor layer is preferably in a form of a porous film formed of semiconductor particles.
Examples of the semiconductor usable in the present invention include element semiconductors such as silicon and germanium, III-V type compound semiconductors, metal chalcogenides (e.g., oxide, sulfide, selenide, and the like, and composites thereof), compounds having a perovskite structure (e.g., strontium titanate, calcium titanate, sodium titanate, barium titanate, potassium niobate, and the like), and the like. Among them, a semiconductor formed of a metal chalcogenide is preferable.
Preferable examples of the metal chalcogenide include oxides of titanium, tin, zinc, iron, tungsten, zirconium,

hafnium, strontium, indium, cerium, yttrium, lanthanum, vanadium, niobium and tantalum; sulfides of cadmium, zinc, lead, silver, antimony and bismuth; selenides of cadmium and lead; a telluride of cadmium; and the like. Examples of other compound semiconductors include phosphides of zinc, gallium, indium, cadmium, and the like; selenides of gallium-arsenic and copper-indium; a sulfide of copper-indium; and the like. Further, a semiconductor formed of a composite such as $M_xO_yS_z$ or $M^1_xM^2_yO_z$ (wherein, each of M, $M^1$ and $M^2$ is a metal atom, O is an oxygen atom, and x, y and z are numbers in a combination which makes the composite neutral according to the atom valence) can also be preferably used.

Specific examples of the semiconductor preferably include Si, $TiO_2$, $SnO_2$, $Fe_2O_3$, $WO_3$, ZnO, $Nb_2O_5$, CdS, ZnS, PbS, $Bi_2S_3$, CdSe, CdTe, GaP, InP, GaAs, $CuInS_2$, $CuInSe_2$, and the like, more preferably include $TiO_2$, ZnO, $SnO_2$, $Fe_2O_3$, $WO_3$, $Nb_2O_5$, CdS, PbS, CdSe, InP, GaAs, $CuInS_2$, and $CuInSe_2$, particularly preferably include $TiO_2$ and $Nb_2O_5$, and most preferably is $TiO_2$. $TiO_2$ containing more anatase-type crystals is more preferable. $TiO_2$ containing 70% or more anatase-type crystals is preferable, and $TiO_2$ consisting of 100 % anatase-type crystals is most preferable.

The semiconductor is preferably doped with a metal to improve electron conductivity in the semiconductor. A preferable metal for doping is a divalent metal or a trivalent metal. In addition, use of a semiconductor doped with a monovalent metal is also preferable since a flow of a reverse current from the semiconductor to a charge transfer layer (described later) can be prevented.

The semiconductor used in the present invention may be a single crystal semiconductor or a polycrystal semiconductor. However, a polycrystal semiconductor is preferable from viewpoints of production costs, procurement of raw materials, energy pay-back time, and the like, and that used in a form of a porous film formed of semiconductor particles is most preferable. Further, a semiconductor partially having an amorphous portion is also usable.

Particle diameters of the semiconductor particles are generally of the order of nm to μm. An average particle diameter of primary particles, which is obtained from diameters of circles converted from projected areas of the particles, is preferably in a range of 5 nm to 200 nm, and more preferably in a range of 8nm to 100 nm. Further, when the semiconductor particles are dispersed in a solvent to prepare a dispersion, and the dispersion is coated on a surface of a conductive support or the like to form a porous semiconductor film, an average particle diameter of semiconductor particles (secondary particles) in the dispersion is preferably in a range of 0.01μm to 30μm. Semiconductor particles of two or more types having different distributions of particle diameter may be used in combination, and in this case, an average particle diameter of small particles is preferably 25 nm or less, and more preferably 10 nm or less. In addition, semiconductor particles having large diameters, for example, 100 nm or more, or about 300 nm are preferably mixed in order to scatter incident light to increase a light capture rate.

Two or more types of semiconductor particles consisting of different materials may be used in combination. When using a combination of two or more types of semiconductor particles, at least one type is preferably selected from $TiO_2$, ZnO, $Nb_2O_5$ and $SrTiO_2$, and at least one of the other types is preferably selected from $SnO_2$, $Fe_2O_3$ and $WO_3$. More preferable combinations include a combination of ZnO and $SnO_2$, a combination of ZnO and $WO_3$, a combination of $SnO_2$ and $WO_3$, and the like. When two or more types of semiconductor particles are used in combination, particle diameters of them may be different from each other. Particularly, a combination of the semiconductor particles of the one type listed above having large diameters and the semiconductor particles of the other types listed above having small diameters is preferable. When using a combination of semiconductor particles consisting of different materials and having different sizes, an average particle diameter of larger semiconductor particles is preferably 100 nm or more, and that of smaller semiconductor particles is preferably 15 nm or less.

Preferable methods for producing the semiconductor particles include a sol-gel process described in "Sol-Gel-ho no Kagaku" (Science of Sol-Gel Process) (written by Sumio Sakubana, published by Agune Shohu-sha, 1998) and "Sol-Gel-ho ni yoru Hakumaku Coating Gijutsu" (Thin Film Coating Technique using Sol-Gel Process) (published by Gijutu Joho Kyokai, 1995) and a sol-gel process described in "Shin-gosei-ho Sol-Gel-ho ni yoru Tanbunsan-ryushi no Gosei to Size Keitai Seigyo" (Synthesis and Size-Form Control of Monodisperse Particle Using a New Synthesis Method: Sol-Gel Process) (written by Tadao Sugimoto) and Materia, vol. 35, No. 9, pp. 1012-1018 (1996). In addition, a method for producing an oxide by hydrolyzing a chloride at a high temperature in an oxyhydrogen salt, which is developed by Degussa, is also preferable.

When the semiconductor particle is titanium oxide, the sol-gel processes and the high-temperature hydrolysis mentioned above are both preferable. In addition, a sulfuric acid method and a chlorine method described in "Sanka-chitan Bussei to Oyo-gijutsu" (Titanium Oxide: Physical Properties and Application Technology) (written by Manabu Kiyono, published by Gihodo, 1997) can also be used. Further, a sol-gel process described in Barbe et al., Journal of American Ceramic Society, vol. 80, No. 12, pp. 3157-3171, 1997, and a sol-gel process described in Burnside et al., Chemistry of Materials, vol. 10, No. 9, pp. 2419-2425, are also preferable.

(B) Bonding Compound for Mordanting (Compound Having NEG(-) Group or POS(+) Group)

A compound having a NEG(-) group or a POS(+) group is bonded to at least the surface of the semiconductor.

The compound having a NEG(-) group or a POS(+) group serves as a so-called mordanting agent for bonding the surface of the semiconductor and a dye (hereinafter also referred to as a "bonding compound for mordanting"}. By modifying the surface of the semiconductor with the bonding compound for mordanting, sites on which the dye can work can be formed on the surface of the semiconductor. Therefore, the bonding compound for mordanting is a compound which can be bonded to a semiconductor to be used, can interact with a dye used as a mordanting dye, and fix the dye on the surface of the semiconductor.

The bonding compound for mordanting is preferably a colorless compound which does not absorb light in visible region. The bonding compound for mordanting which does not absorb light in visible region is preferable because a lowering in efficiency caused by the bonding compound for mordanting absorbing light (filter effect) can be prevented.

(Bonding Compound for Mordanting Having NEG(-) Group)

The bonding compound for mordanting having a NEG(-) group may be an organic compound or an inorganic compound, and preferably is an organic compound. When the bonding compound for mordanting absorbs light in visible region, the compound preferably sensitizes the semiconductor, and a preferable example is a metal complex dye (particularly a ruthenium complex dye).

The bonding compound for mordanting having a NEG(-) group is preferably a compound represented by the following general formula (1).

General Formula (1)

$$(Y^2)_n\text{—A—}Y^1\text{-B}$$

In general formula (1), A is a carbonyl group, phosphonyl group, sulfonyl group, silyl group or borane. n is 1 if A is a carbonyl group or a sulfonyl group, n is 2 if A is a phosphonyl group or borane, and n is 3 if A is a silyl group. A is preferably a carbonyl group or a silyl group, and more preferably a carbonyl group.

$Y^1$ is a divalent group having a steric structure which is necessary so that A and B can not form bonds to the semiconductor at the same time (i.e., only A forms a bond to the semiconductor). $Y^1$ is preferably a divalent group represented by the following general formula (3).

General Formula (3)

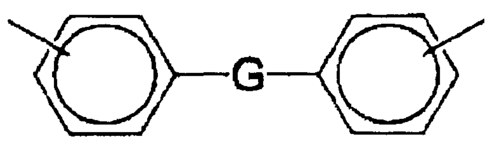

In general formula (3), G is an alkyl group, oxygen atom, sulfon group, ester group, amide group, imide group or single bond. G is preferably an alkyl group or an oxygen atom, and more preferably is an alkyl group.

In general formula (1), B is a carboxylic group, sulfonic group, phosphonic group, phosphoric group, silicic group, boric group or hydroxyl group, or a hydrogen-dissociated form of each. B is preferably a hydrogen-dissociated form of a carboxylic group, sulfonic group, phosphonic group, phosphoric group, silicic group, boric group or hydroxyl group, and more preferably a hydrogen-dissociated form of a carboxylic group or a sulfonic group. B also includes a group (precursor) which easily forms one of the acid groups by hydrolysis and the like, or the hydrogen-dissociated form thereof.

In general formula (1), $Y^2$ is an alkoxy group, aryloxy group, hydroxyl group, halogen atom or hydrogen atom. $Y^2$ is a group which is entirely or partially eliminated if the compound represented by general formula (1) reacts with the semiconductor, and is substituted with an atom of the semiconductor. If a plurality of reacting sites are present in a molecule (if n is 2 or 3), all the sites may form bonds to the semiconductor, or some of the sites may react with the semiconductor to form bonds.

Specific examples of the compound represented by general formula (1) (exemplary compounds E-1 to E-9, including the precursors) are shown below, however, these are not intended to limit the compound used in the present invention.

E-1

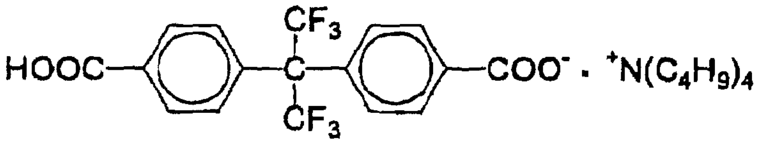

E-2

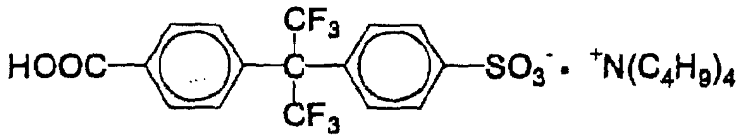

E-3

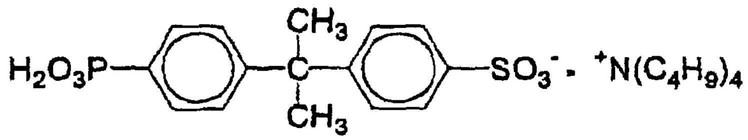

E-4

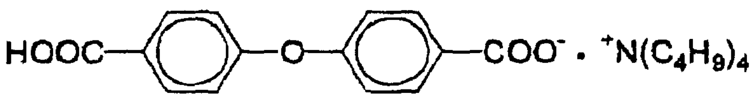

E-5

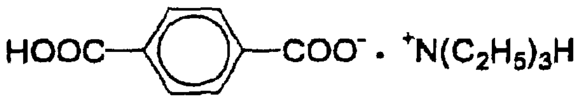

E-6

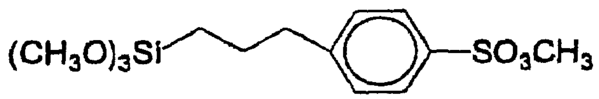

E-7

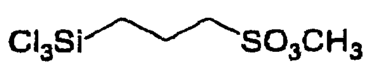

E-8

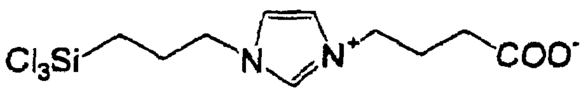

E-9

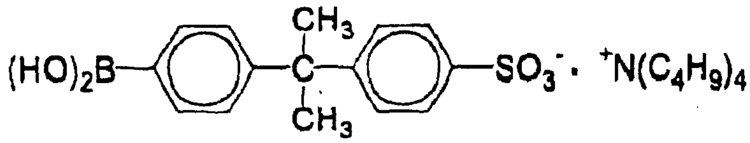

The semiconductor to which the bonding compound for mordanting has been bonded preferably has, at least at the surface thereof, a structure represented by the following general formula (2).

General Formula (2)

$$(P_{SC}-O)_n-A-Y^1-B$$

In general formula (2), $P_{sc}$ is the semiconductor and O is an oxygen atom. The oxygen atom may be derived from the semiconductor, from the bonding compound for mordanting, or from a solvent or other reagents used at a time of the reaction between the semiconductor and the bonding compound for mordanting. Definitions of A, B, n and $Y^1$ in general formula (2) are the same as those in general formula (1), and preferable ranges thereof are also the same.

(Bonding Compound for Mordanting Having POS(+) Group)

The bonding compound for mordanting having a POS(+) group is preferably a compound represented by the following general formula (10) or (11).

General Formula (10)

$$Z^1\left[(B^1)_{p1}-M^1-(X^1)_{n1}\right]_{m^1}$$

General Formula (11)

$$Z^2\left[(B^2)_{p2}-M^2-(X^2)_{n2}\right]_{m^2}\cdot(A)_q$$

In general formula (10), $Z^1$ is a basic substituent having a conjugate acid's (a compound represented by H-$Z^1$(+)-H) pKa between 3 and 20. Preferably, $Z^1$ is a basic substituent having the conjugate acid's pKa between 4 and 15, and more preferably a basic substituent having the conjugate acid's pKa between 5 and 12, Specific examples of $Z^1$ include a pyridyl group, imidazolyl group, triethylamino group, morpholyl, guanidyl group, and the like. Preferably, $Z^1$ does not include chromophores (have practically no aborbance in visible light region).

In general formula (10), $B^1$ is a divalent bonding group and $p^1$ is 0 or 1. If $p^1$ is 0, $Z^1$ is directly bonded to $M^1$. Examples of $B^1$ include an alkylene group, arylene group, -O-, -S-, -N(R)- (R is a hydrogen atom or an alkyl group), -CO-, -$SO_2$-, and divalent bonding groups formed of two or more of them in combination.

In general formula (10), $M^1$ is Si, Ti, Al, Ge or Sn, and preferably is Si.

In general formula (10), $X^1$ is an alkoxy group (such as methoxy, ethoxy, or the like), an aryloxy group (such as phenyloxy), a halogen atom (such as a chlorine atom), a hydroxyl group or a hydrogen atom. Among then, an alkoxy group is preferable.

In general formula (10), $m^1$ is an integer from 1 to 3, and $n^1$ is a number of $X^1$ which can be coordinated to $M^1$, which is usually 2 to 3. If $m^1$ is larger than or equal to 2, one combination of $B^1$, $M^1$, $X^1$, $p^1$ and $n^1$ may be the same as and may be different from another combination thereof.

In general formula (11), $Z^2$ is an atomic group having a cation. The atomic group preferably includes a nitrogen cation, phosphorus cation, oxygen cation, sulfur cation or carbon cation, more preferably includes a nitrogen cation or a phosphorus cation, and most preferably includes a nitrogen cation. Examples of $Z^2$ include a quaternary ammonium cation, pyridinium cation, imidazolium cation, morpholium cation, guanidium cation, and the like. Preferably, $Z^2$ does not include chromophores (does not absorb light in visible region).

In general formula (11), A is an anion and q is a number of A which is necessary to make a cationic charge of $Z^2$ and an anionic charge of A equal. Preferable examples of A include a halide ion (such as $Cl^-$, $Br^-$, $I^-$, and the like), $SCN^-$, $BF_4^-$, $PF_6^-$, $ClO_4^-$, $(CF_3SO_2)_2N^-$, $(CF_3CF_2SO_2)_2N^-$, $CF_3SO_3^-$, $CF_3COO^-$, $Ph_4B^-$, $(CF_3SO_2)_3C^-$, and the like.

Definitions of $B^2$, $M^2$ and $X^2$ in general formula (11) are the same as those of $B^1$, $M^1$ and $X^1$ in general formula (10) respectively. In general formula (11), $p^2$ is 0 or 1. If $p^2$ is 0, $Z^2$ is directly bonded to $M^2$. In general formula (11), $m^2$ is an integer from 1 to 3, and $n^2$ is a number of $X^2$ which can be coordinated to $M^2$, which is usually 2 to 3. If $m^2$ is larger than or equal to 2, one combination of $B^2$, $M^2$, $X^2$, $p^2$ and $n^2$ may be the same as and may be different from another combination thereof.

The compound represented by general formula (10) or (11) is bonded to the semiconductor with all or part of $X^1$ or $X^2$ being substituted with bonding sites of the semiconductor. If a plurality of reacting sites are present in a molecule (if $m^1$ or $m^2$ is 2 or 3 respectively), all the sites may form bonds to the semiconductor, or some of the sites may react with the semiconductor to form bonds.

Specific examples of the compound represented by general formula (10) (exemplary compounds 1-1 to 1-8) and of the compound represented by general formula (11) (exemplary compounds 2-1 to 2-11) are shown below, however, these are not intended to limit the present invention.

1 — 1

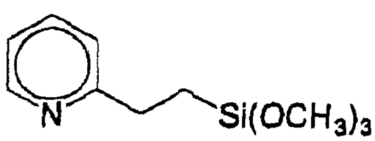

1 — 2

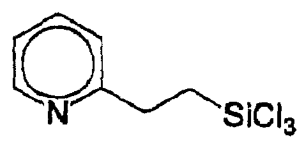

1 — 3

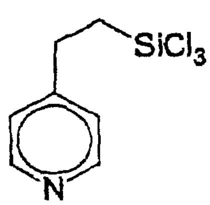

1 — 4

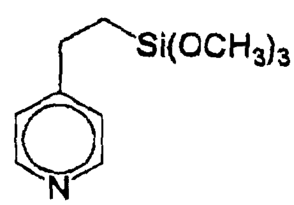

1 − 5

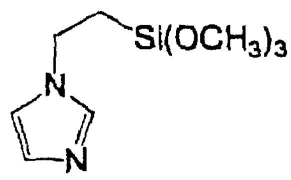

1 − 6

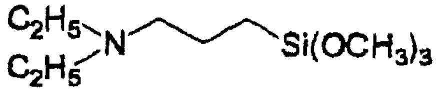

1 − 7

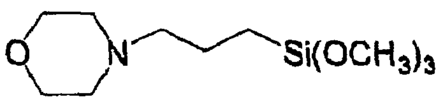

1 − 8

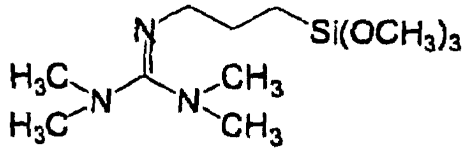

2 − 1

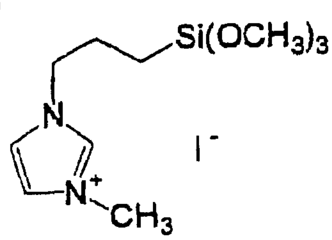

2 − 2

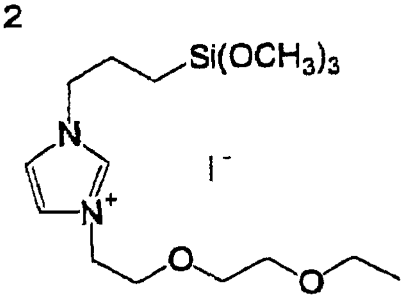

2 − 3

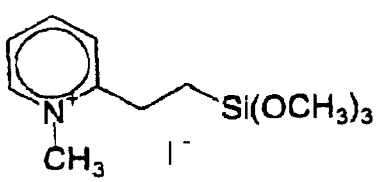

2 − 4

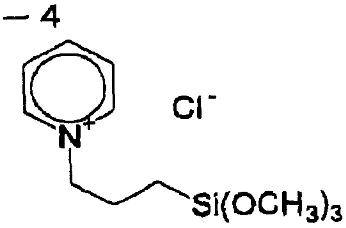

2 — 5

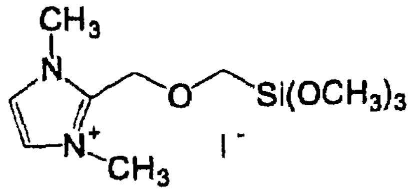

2 — 6

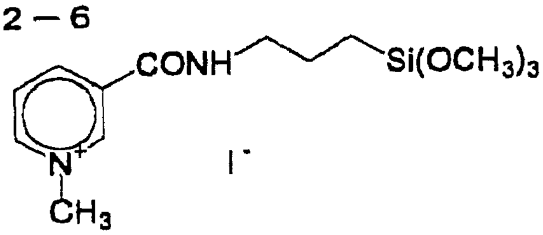

2 — 7

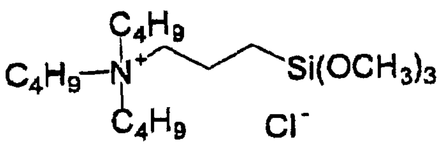

2 — 8

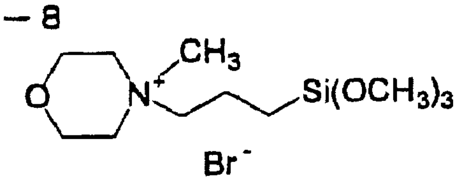

The semiconductor to which the bonding compound for mordanting has been bonded preferably has, at least at the surface thereof, a structure represented by the following general formula (13), (14).

General Formula (13)

$$\left[ (P_{sc}-O)_{n1}-M^{1}-(B^{1})_{p1} \right]_{m1}-Z^{1}$$

General Formula (14)

$$\left[ (P_{sc}-O)_{n2}-M^{2}-(B^{2})_{p2} \right]_{m2}-Z^{2}\cdot(A)_{q}$$

In general formula (13), (14), $P_{sc}$ is the semiconductor and O is an oxygen atom. The oxygen atom may be derived from the semiconductor, from the bonding compound for mordanting, or from a solvent or other reagents used at a time of the reaction between the semiconductor and the bonding compound for mordanting. Definitions of $Z^1$, $Z^2$, $B^1$, $B^2$, $p^1$, $p^2$, $M^1$, $M^2$, $m^1$, $m^2$, A and q in general formula (13), (14) are the same as those in general formulae (10) and (11) respectively.

(C) Dye (Dye Having POS(+) Group or NEG(-) Group)

The semiconductor for photoelectric conversion of the present invention is produced by mordanting the surface of the semiconductor with a dye. The dye electrostatically interacts with the bonding compound for mordanting (e.g., the compound represented by general formula (1) or the compound represented by general formula (10) or (11)) bonded to the semiconductor and is fixed to mordant the semiconductor. The dye has a NEG(-) group or a POS(+) group which can form an ionic bond to the bonding compound for mordanting. When a compound having the NEG(-) group is used as the bonding compound for mordanting, the dye having the POS(+) group is used as the dye, and

when a compound having the POS(+) group is used as the bonding compound for mordanting, a dye having the NEG (-) group is used as the dye. Further, when a compound having a cationic group among the POS(+) groups is used as the bonding compound for mordanting, a dye having an anionic group among the NEG(-) groups is used as the dye, and when a compound having a basic group among the POS(+) groups is used as the bonding compound for mordanting, a dye having an acidic group among the NEG(-) groups is used as the dye.

(Dye Having POS(+) Group)

The basic group of the dye is a group having a conjugate acid's pKa between 3 and 20, and preferably between 5 and 12 (e.g., pyridyl group, imidazolyl group, a group including tertiary amine, guanidino group, or the like).
Examples of the dye include generally available organic dyes (such as cyanine dyes, merocyanine dyes, oxonol dyes, and the like), phthalocyanine dyes, porphyrin dyes, metal complex dyes, and the like. Preferably, the dye is a metal complex dye, and more preferably, a metal complex dye represented by the following general formula (4).

General Formula (4)

$$M(La)_{m1}(Lb)_{m2}(X)_{m3} \cdot CI$$

In general formula (4), M is a metal atom. M is preferably a metal atom which can be four-coordinated or six-coordinated, more preferably is Ru, Fe, Os, Cu, W, Cr, Mo, Ni, Pd, Pt, Co, Ir, Rh, Re, Mn or Zn, still more preferably is Ru, Fe, Os or Cu, and most preferably is Ru.
In general formula (4), La is a bidentate or tridentate ligand represented by the following general formula (5), and m1 is an integer from 1 to 3.

General Formula (5)

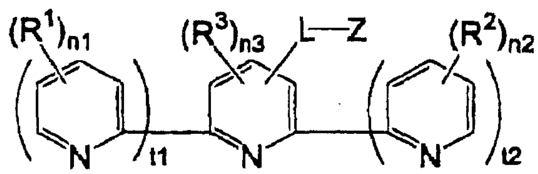

In general formula (5), Z is a group containing a nitrogen cation. Examples of Z include imidazolium, pyridinium, quaternary ammonium, thiazolium, oxazolium, quinolinium, benzoimidazolium, benzothiazolium, benzooxazolium, and the like. Z is preferably a group represented by one of the following general formulae (7)-(9).

General Formula (7)

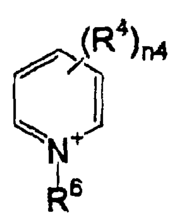

General Formula (8)

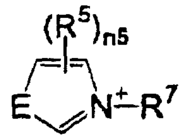

General Formula (9)

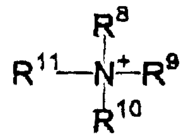

In general formulae (7)-(9), each of $R^4$ to $R^{11}$ is a substituent, and is preferably a hydrogen atom, an alkyl group, alkenyl group, cycloalkyl group, aryl group, heterocyclic group, amino group, alkoxy group, acyl group or alkoxycarbonyl group, more preferably an alkyl group, and most preferably an alkyl group having 1 to 5 carbon atoms.

In general formula (7), n4 is an integer from 1 to 5, and in general formula (8), n5 is an integer from 1 to 3. If n4 is larger than or equal to 2, one $R^4$ may be the same as and may be different from another $R^4$, and if n5 is larger than or equal to 2, one $R^5$ may be the same as and may be different from another $R^5$. $R^4$s may be bonded to each other, and $R^5$s may be bonded to each other.

In general formula (8), E is an oxygen atom, sulfur atom or-$NR^{12}$-, and $R^{12}$ is a substituent. Preferably, E is -$NR^{12}$-. The substituent represented by $R^{12}$ may be one of the substituents $R^4$ to $R^{11}$, and preferably is an unsubstituted alkyl group or a substituted alkyl group (such as alkoxy alkyl group, or the like).

One of $R^4$ and $R^6$ in general formula (7) is bonded to L in general formula (5), one of $R^5$, $R^7$ and $R^{12}$ in general formula (8) is bonded to L in general formula (5), and one of $R^8$ to $R^{11}$ in general formula (9) is bonded to L in general formula (5).

In general formula (5), L is a bonding group. Examples of a group forming a main-chain portion of L include an alkylene group and an arylene group. L is preferably an alkylene group having 1 to 10 carbon atoms. Examples of bonds between L and Z, and between L and the pyridine ring respectively include a single bond, amide bond, ester bond, ether linkage, and the like. Preferably, L and Z, as well as L and the pyridine ring are respectively bonded together by single bonds.

In general formula (5), each of $R^1$, $R^2$ and $R^3$ is a substituent, and preferably is a hydrogen atom, an alkyl group, alkenyl group, cycloalkyl group, aryl group, heterocyclic group, amino group, alkoxy group, acyl group or alkoxycarbonyl group, more preferably is an alkyl group, and most preferably an alkyl group having 1 to 5 carbon atoms. Each of n and n2 is an integer from 1 to 4, and n3 is an integer from 1 to 3. If n1, n2 and n3 are respectively larger than or equal to 2, two or more of $R^1$s, $R^2$s and $R^3$s may be the same or different respectively, and $R^1$s, $R^2$s and $R^3$s may be respectively bonded between $R^1$s, between $R^2$s and between $R^3$s. Each of t1 and t2 is an integer from 0 to 2, and a sum of t1 and t2 is smaller than or equal to 2. If t1 and t2 are respectively 0, substitution positions of L and $R^3$ can be on a carbon neighboring a nitrogen in the pyridine ring.

In general formula (4), Lb is a bidentate or tridentate ligand represented by the following general formula (6). m2 is an integer from 0 to 2.

General Formula (6)

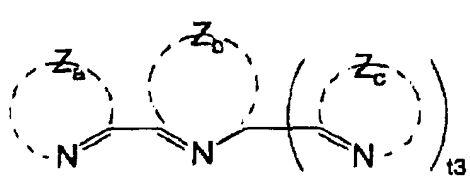

In general formula (6), each of $Z_a$, $Z_b$ and $Z_c$ is a nonmetal atomic group which can form five- or six-membered ring, and preferably consists of at least one of carbon atom, hydrogen atom, nitrogen atom, oxygen atom, sulfur atom, phosphorus atom, and halogen atom. $Z_a$, $Z_b$ and $Z_c$ preferably form aromatic rings. Specific examples of the aromatic ring preferable in the present invention include aromatic five-membered rings such as an imidazole ring, oxazole ring, thiazole ring, triazole ring, and the like; and aromatic six-membered rings such as a pyridine ring, pyrimidine ring, pyridazine ring, pyrazine ring, and the like. Among them, a pyridine ring and an imidazole ring are preferable, and a pyridine ring is most preferable.

In general formula (6), t3 is 0 or 1, and preferably is 0.

In general formula (4), X is a monodentate or bidentate ligand. m3 is an integer from 0 to 4, and if m3 is larger than or equal to 2, two or more of Xs may be the same or different, and Xs may be bonded to each other. Examples of X include a monodentate or bidentate ligand with a coordinating group selected from a group consisting of an acyloxy group (preferably having 1 to 20 carbon atoms, such as acetyloxy, benzoyloxy, oxalylene (-OC(=O)C(=O)O-)), an acylthio group (preferably having 1 to 20 carbon atoms, such as acetylthio, benzoylthio), an acylaminooxy group (preferably having 1 to 20 carbon atoms, such as N-methylbenzoylaminooxy ($PhC(=O)N(CH_3)O-$), an acetylaminooxy ($CH_3C(=O)NHO-$)), a thioacyloxy group (preferably having 1 to 20 carbon atoms, such as thioacetyloxy ($CH_3C(=S)O-$)), a thioacylthio group (preferably having 1 to 20 carbon atoms, such as thioacetylthio ($CH_3C(=S)S-$), thiobenzoylthio (PhC(=S)S-)), a thiocarbonate group (preferably having 1 to 20 carbon atoms, such as ethyltrithiocarbonate ($C_2H_5SC(=S)S-$), phenyltrithiocarbonate (PhSC(=S)S-)), a dithiocarbonate group (preferably having 1 to 20 carbon atoms, such as ethyldithiocarbonate ($C_2H_5OC(=S)S-$)), a trithiocarbonate group (preferably having 1 to 20 carbon atoms, such as ethyltrithiocarbonate group ($C_2H_5SC(=S)S-$)), an alkylthio group (preferably having 1 to 20 carbon atoms, such as methanethio, ethylenedithio), an arylthio group (preferably having 6 to 20 carbon atoms, such as benzenethio, 1,2-phenylenedithio), an alkoxy group (preferably having 1 to 20 carbon atoms, such as methoxy, ethylenedioxy) and an aryloxy group (preferably having 6 to 20 carbon atoms, such as phenoxy, 1,2-benzenedioxy).

Examples of X further include a monodentate or bidentate ligand such as β-diketonate (preferably having 3 to 20 carbon atoms, such as $CH_3C(O\cdots)CH=C(O-)CH_3$; wherein and hereinafter "···" represents a coordinate bond), β-dithioketonate (preferably having 3 to 20 carbon atoms, such as $CH_3C(S\cdots)CH=C(S-)CH_3$),β-ketothionate (preferably having 3 to 20 carbon atoms, such as $CH_3C(O\cdots)CH=C(S-)CH_3$), β-thioketonate (preferably having 3 to 20 carbon atoms, such as $CH_3C(S\cdots)CH=C(O-)CH_3$), dialkylketone (preferably having 3 to 20 carbon atoms, such as dimethylketone ( $(CH_3)_2CO\cdots$), carbonamide (preferably having 1 to 20 carbon atoms), thiocarbonamide (preferably having 1 to 20 carbon atoms), thiourea (preferably having 1 to 20 carbon atoms), isothiourea (preferably having 1 to 20 carbon atoms), halogen, water, isocyanate, cyanate, isothiocyanate, thiocyanate, and the like. Preferably, X is halogen, isocyanate, cyanate, isothiocyanate or thiocyanate, and most preferably, X is isothiocyanate (NCS).

In general formula (4), CI is a counter ion which may be necessary to neutralize an electric charge. When n anions (n is a real number) are necessary to neutralize an electric charge, CI is n anions. Whether the dye portion other than CI in general formula (4) is a cation or an anion, or has a net ionic charge depends on a metal atom included in the dye portion, the types of a ligand and a substituent included in the ligand and combinations thereof. When the substituent has a dissociative group, the dissociative group may have a negative charge by dissociation. In this case, also, the electric charge of the molecule as a whole is neutralized by CI.

When CI is a cation, specific examples of typical cations include an inorganic or organic ammonium ion (such as a tetraalkylammonium ion, a pyridinium ion) and an alkali metal ion. On the other hand, when CI is an anion, it may be inorganic or organic and examples thereof include a halogen anion (such as a fluoride ion, chloride ion, bromide ion, iodide ion), an aryl-substituted sulfonate ion (such as p-toluene sulfonate ion, p-chlorobenzene sulfonate ion), an aryl disulfonate ion (such as 1,3-benzene disulfonate ion, 1,5-naphthalene disulfonate ion, 2,6-naphthalene disulfonate ion), an alkyl sulfate ion (such as methylsulfate ion), a sulfate ion, a thiocyanate ion, a perchlorate ion, a tetrafluoroborate ion, a hexafluorophosphate ion, a picrate ion, an acetate ion and a trifluoromethane sulfonate ion. Further, an ionic polymer or other dye having an anti-charge with respect to the dye portion may be used as CI. A metal complex ion (such as bisbenzene-1,2-dithiolato nickel (III)) can also be used as CI.

Specific examples of the compound represented by general formula (4) (exemplary compounds D-1 to D-8) are shown below, however, these are not intended to limit the dye used in the present invention.

D-1

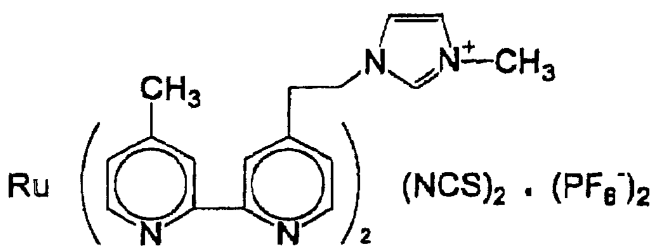

D-2

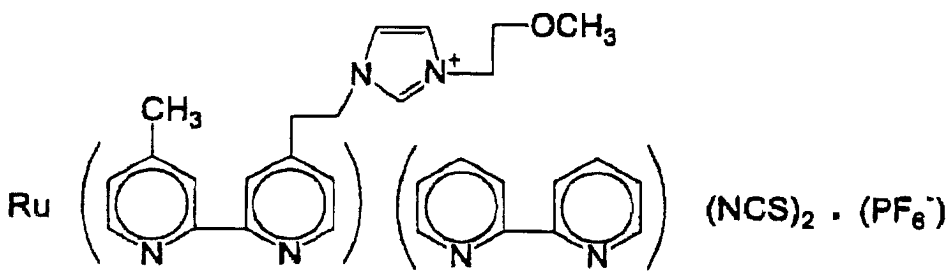

D-3

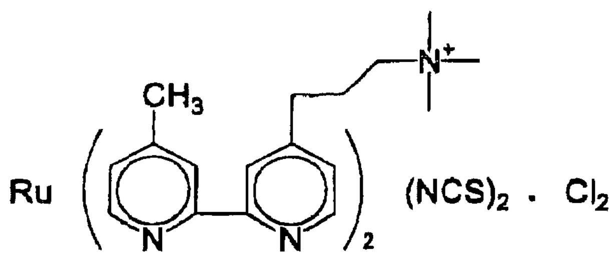

D-4

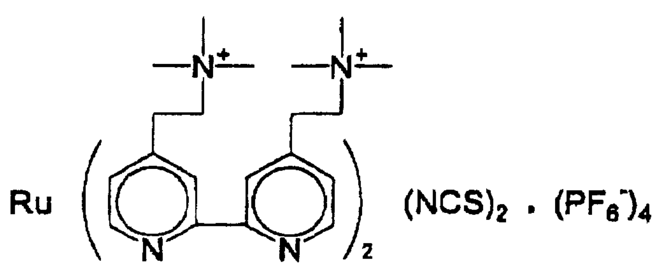

D-5

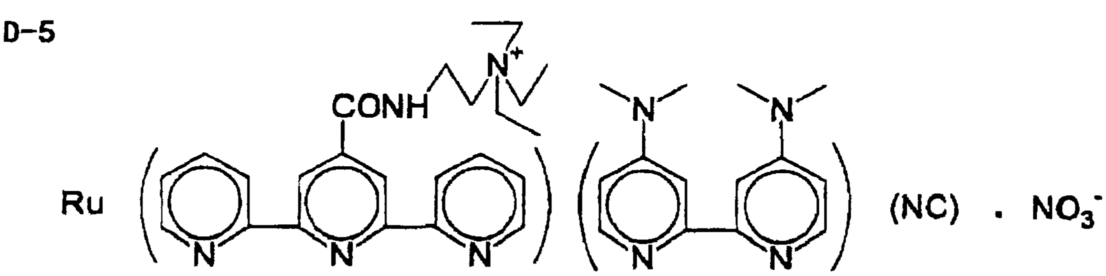

D-6

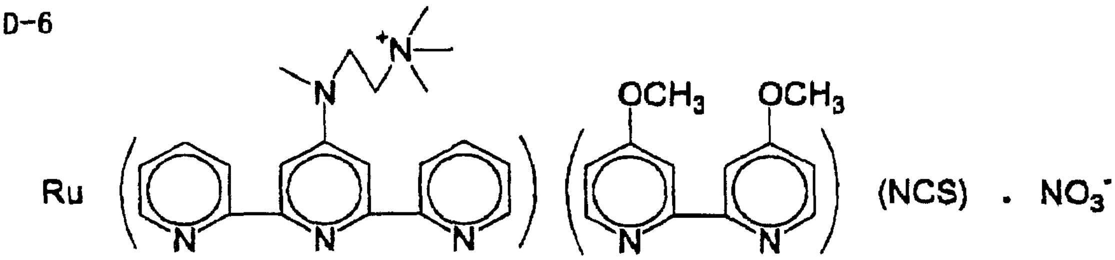

D-7

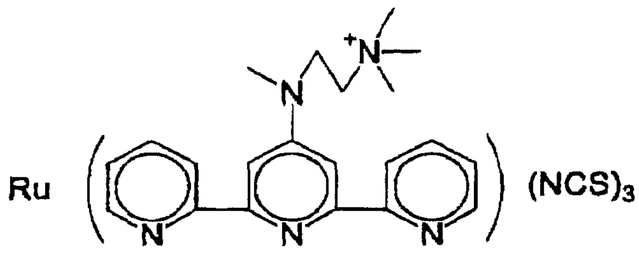

D-8

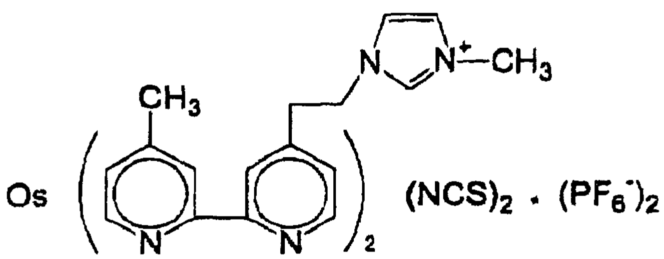

The compound represented by general formula (4) can be synthesized with reference to a method cited in literature such as Inorganic Chemistry, 37, 5251 (1998), and the like.

In the present invention, the dye may be used singly or in combination of two or more types. For example, known dyes such as ruthenium complex dyes, an organic dyes, and the like may be used in combination with the metal complex dye represented by general formula (4).

(Dye Having NEG(-) Group)

The dye is preferably a compound represented by the following general formula (12)

General Formula (12)

$$\text{Dye}—(\text{Y})_r$$

In general formula (12), Dye is a dye residue. The dye residue refers to a residue having a chromophore, which is left after removing r substituents or r hydrogen atoms from a dye compound having the chromophore.

In general formula (12), Y is a NEG(-) group. When Y is an acidic group among NEG(-) groups, the acidic group preferably makes a pKa of the compound represented by $CH_3$-Y between -2 and 16, and more preferably between -2 and 10. Specific examples of Y include-COOH group, -OH group, -$SO_3H$ group, -P(O)$(OH)_2$ group, -OP(O)$(OH)_2$ group, and the like. Among them, -COOH group, -P(O)$(OH)_2$ group or - OP(O)$(OH)_2$ group is particularly preferable, When Dye in general formula (12) is a polymethine dye and a methine chain thereof forms a squarylium ring or a croconium ring, the squarylium ring or the croconium ring may be the acidic group. When Y is an anionic group among the NEG(-) group, Y is preferably an anionic group which is formed by removing a proton from the acidic groups included in the preferable examples of the acidic group. When Y is an anionic group, Y can have a cation which is necessary

to neutralize the charge of the anionic group. Examples of the cation include an alkali metal cation, a quaternary ammonium cation, a cation which is obtained by quaternarization of a nitrogen-containing aromatic ring, such as a pyridinium cation or a imidazolium cation, and the like.

In general formula (12), r is an integer from 1 to 6. If r is larger than or equal to 2, two or more of Ys may be the same or different from each other.

The dye is preferably a metal complex dye, a phthalocyanine type dye or a methine dye, and more preferably, a metal complex dye or a methine dye. The dye may be a combination of two or more types of dyes, and in which case, the types and ratio of dyes to be combined can be suitably selected.

Preferable dyes are described in detail below.

(a) Metal Complex Dye

Among metal complex dyes, a metal phthalocyanine dye, a metal porphyrin dye and a ruthenium complex dye are preferable, and a ruthenium complex dye is particularly preferable. Examples of the ruthenium complex dye are described in US Patens Nos. 4,927,721, 4,684,537, 5,084,365, 5,350,644, 5,463,057, 5,525,440, Japanese Patent Application Laid-Open (JP-A) No. 7-249790, Japanese National Publication No. 10-504512, International Patent No. 98/50393, JP-A No. 2000-26487, and the like.

The ruthenium complex dye is preferably a compound represented by the following general formula (15).

General Formula (15)

$$(A^1)_t Ru(B\text{-}a)_u (B\text{-}b)_v (B\text{-}c)_w$$

In general formula (15), $A^1$ is a monodentate or bidentate ligand. $A^1$ is preferably a ligand selected from a group consisting of Cl, SCN, $H_2O$, Br, I, CN, NCO, SeCN, β -diketones, and derivatives of oxalic acid and dithiocarbamic acid. t is an integer from 0 to 3, each of u, v and w is 0 or 1, and they are suitably combined depending on the type of the ligand so that the ruthenium complex represented by general formula (15) become a six-coordinate complex. If t is larger than or equal to 2, two or more of $A^1$s may be the same or different. In general formula (15), each of B-a, B-b and B-c is a ligand represented by any one of the following formulae (B-1) to (B-10).

B-1

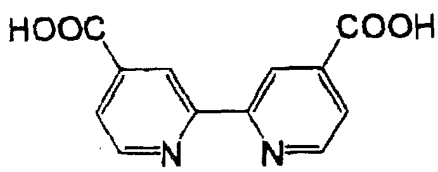

B-2

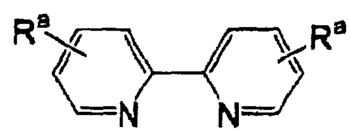

B-3

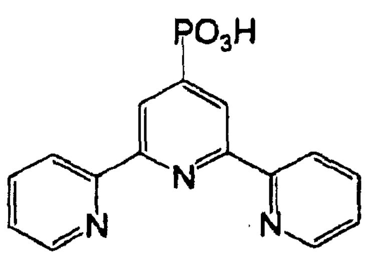

B-4

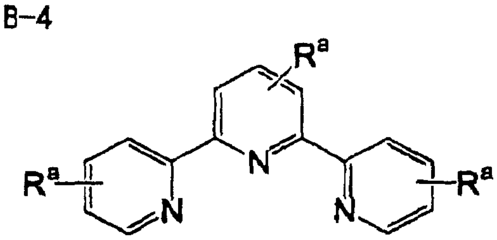

B-5

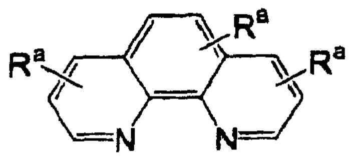

B-6

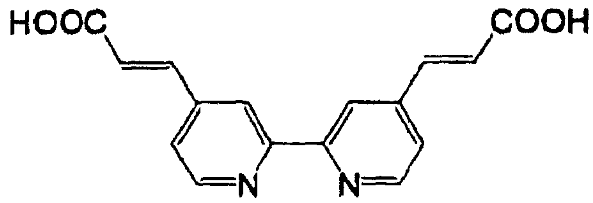

B-7

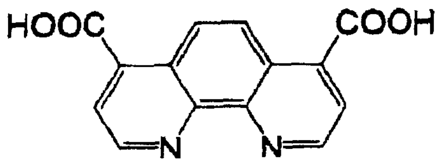

B-8

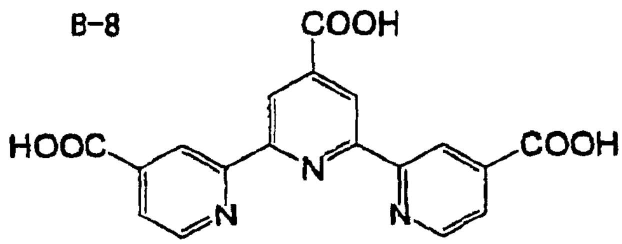

B-9

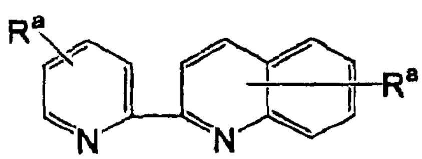

B-10

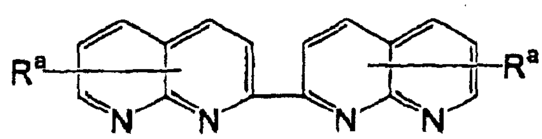

In formulae (B-1) to (B-10), $R^a$ is a hydrogen atom or a substituent. Examples of the substituent represented by $R^a$ include a halogen atom, a substituted or unsubstituted alkyl group having 1 to 12 carbon atoms, a substituted or unsubstituted aralkyl group having 7 to 12 carbon atoms, a substituted or unsubstituted aryl group having 6 to 12 carbon atoms, and the NEG(-) groups described above. The substituent represented by $R^a$ may further be substituted by other substituent, and examples of the other substituent include the NEG(-) groups described above. Alkyl portions of the alkyl group and the aralkyl group may be straight chains or branched chains. Aryl portions of the aryl group and the aralkyl group may be monocyclic or polycyclic (condensed ring, ring assembly).

In general formula (15), B-a, B-b and B-c may be the same or different. The compound represented by general formula (15) include the at least one NEG(-) group.

Specific examples of the organic metal complex dye preferable in the present invention (exemplary compound R-1 to R-17) are shown below, however, these are not intended to limit the dye used in the present invention.

| $(A^1)_pRu(B\text{-}a)\ (B\text{-}b)\ (B\text{-}c)$ | | | | | | |
|---|---|---|---|---|---|---|
| | $A^1$ | p | B-a | B-b | B-c | $R^a$ |
| R-1 | SCN | 2 | B-1 | B-1 | - | - |
| R-2 | CN | 2 | B-1 | B-1 | - | - |
| R-3 | Cl | 2 | B-1 | B-1 | - | - |
| R-4 | CN | 2 | B-7 | B-7 | - | - |
| R-5 | SCN | 2 | B-7 | B-7 | - | - |
| R-6 | SCN | 2 | B-1 | B-2 | - | H |
| R-7 | SCN | 1 | B-1 | B-3 | - | - |

(continued)

| (A1)pRu(B-a) (B-b) (B-c) | | | | | | |
|---|---|---|---|---|---|---|
| | $A^1$ | p | B-a | B-b | B-c | $R^a$ |
| R-8 | Cl | 1 | B-1 | B-4 | - | H |
| R-9 | I | 2 | B-1 | B-5 | - | H |
| R-10 | SCN | 3 | B-8 | - | - | - |
| R-11 | CN | 3 | B-8 | - | - | - |
| R-12 | SCN | 1 | B-2 | B-8 | - | H |
| R-13 | - | 0 | B-1 | B-1 | B-1 | - |

R-14

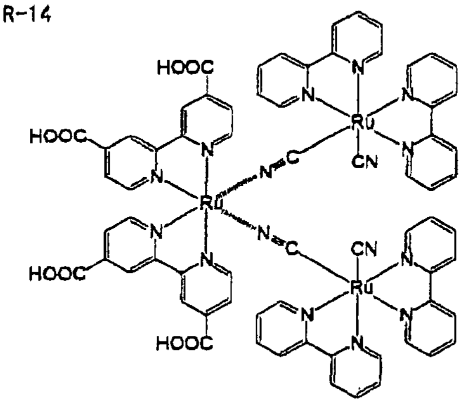

R-15

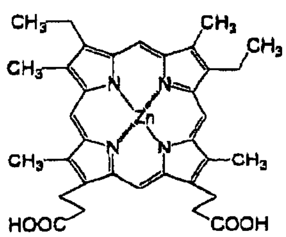

R-16

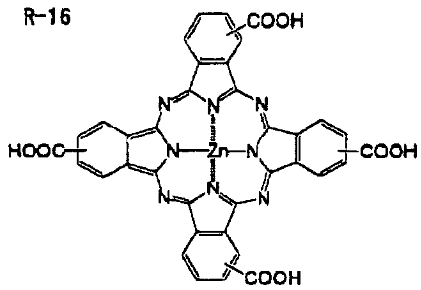

R-17

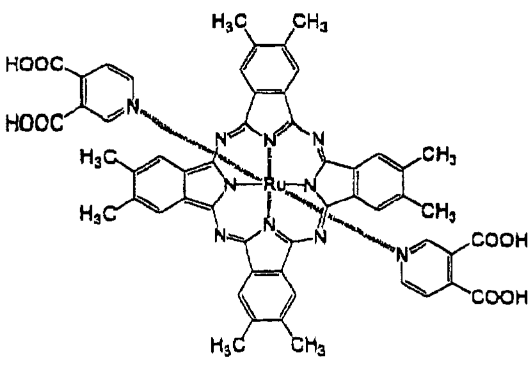

(B) Methine Dye

Examples of the methine dye include polymethine dyes such as a cyanine dye, a merocyanine dye, a

squarylium dye, and the like. The methine dye has the at least one NEG(-) group. Preferable examples of the methine dye include those described in JP-A Nos. 11-35836, 11-67285, 11-86916, 11-97725, 11-158395, 11-163378, 11-214730, 11-214731 and 11-238905, and European Patent Nos. 892411 and 911841.

Specific examples of the methine dyes preferable in the present invention (exemplary compounds M-1 to M-8) are shown below, however, these are not intended to limit the dye used in the present invention.

M-1

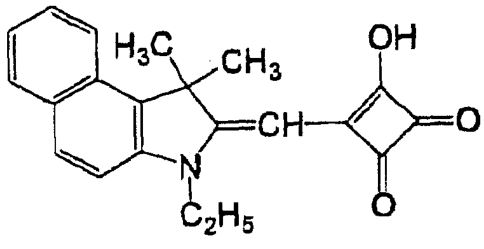

M-2

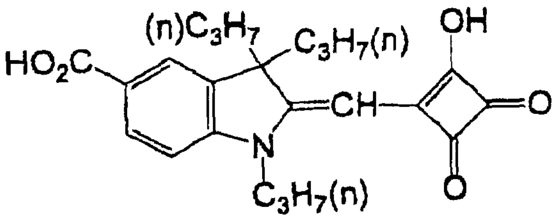

M-3

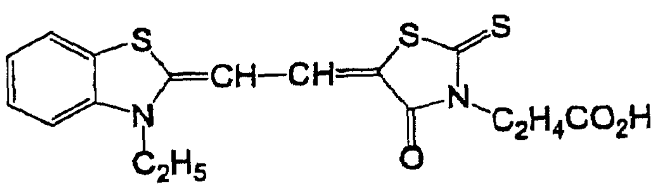

M-4

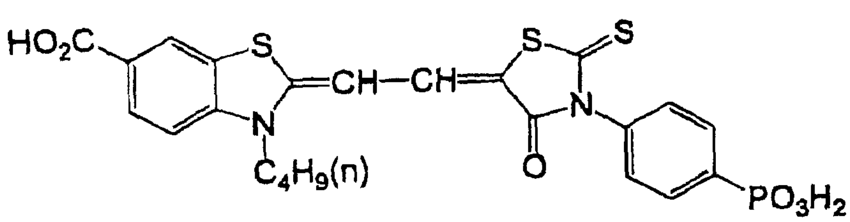

M-5

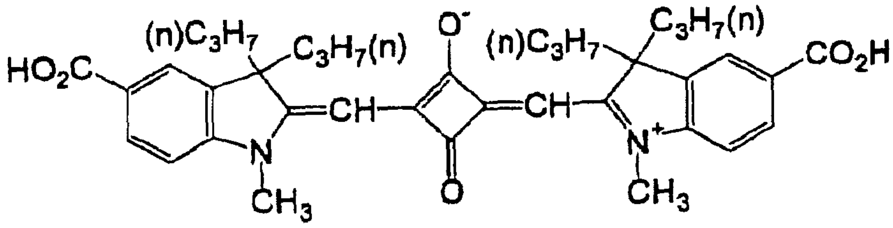

M-6

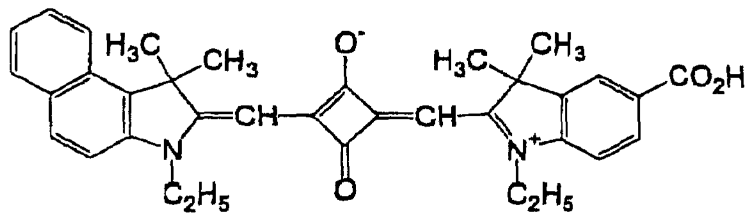

M-7

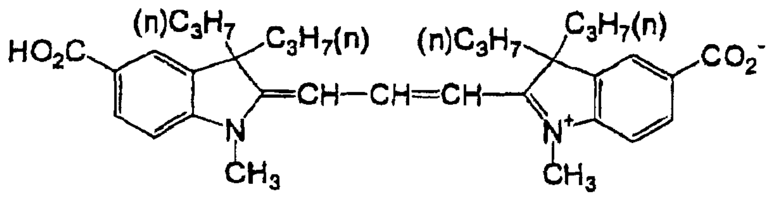

M-8

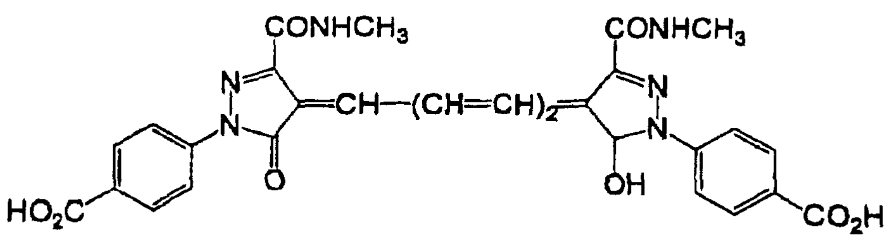

(D) Method for Producing Semiconductor for Photoelectric Conversion of the Present Invention

The semiconductor for photoelectric conversion of the present invention can be produced by a step of bonding the compound having the NEG(-) group or the POS(+) group to at least the surface of the semiconductor, and a step of mordanting the semiconductor by making the dye having the POS(+) group or the NEG(-) group interact with the compound bonded to the surface. Bonding of the bonding compound for mordanting to the surface of the semiconductor and mordanting of the bonding compound for mordanting which is bonded to the surface with the dye may be carried out directly on a semiconductor substrate formed of a semiconductor, or may be carried out in a form of a semiconductor layer (preferably a porous film) formed by coating a coating solution containing the semiconductor particles on a support (particularly, a conductive support). Bonding of the bonding compound for mordanting and mordanting the bonding compound for mordanting which is bonded to the surface with the dye is preferably carried out in the form of the semiconductor layer formed on the support, since it improves photoelectric conversion characteristics of the resulting semiconductor for photoelectric conversion, and it is easier in operation.

The respective steps are described below.

(a) Process of Bonding the Bonding Compound for Mordanting to the Surface of the Semiconductor

The bonding compound for mordanting (preferably a compound represented by general formula (1), (10) or (11)) can be bonded to the surface of the semiconductor by making a solution containing the bonding compound for mordanting at least contact the surface of the semiconductor, and heating as desired. Contacting the solution to the surface can be carried out, for example, by dipping the semiconductor in the solution, coating the solution on the surface of the semiconductor, or the like. The dipping is preferably carried out at room temperature for 5 hours to 5 days. When the dipping is carried out while the solution is heated, it is preferably carried out for 1 to 24 hours. When the semiconductor is in a form of a semiconductor layer formed on a support, the semiconductor together with the support can be dipped in the solution, or the solution can be coated on the semiconductor layer. The reaction between the semiconductor and the bonding compound for mordanting may be carried out at room temperature, or while being heated. In order to increase a degree of the reaction between the semiconductor and the bonding compound for mordanting, the semiconductor is preferably subjected to a heat treatment prior to the reaction. After the heat treatment, the semiconductor is preferably kept at 40 to 80°C without cooled to room temperature and is reacted with the bonding compound for mordanting immediately in order to prevent the surfaces of the semiconductor particles from adsorbing water.
A solvent used for preparing the solution containing the bonding compound for mordanting can be suitably selected depending on a solubility of the bonding compound for mordanting. Examples of the solvent include alcohols (such as methanol, ethanol, t-butanol, benzylalcohol, and the like), nitriles (such as acetonitrile, propionitrile, 3-methoxypropionitrile, and the like), nitromethane, halogenated hydrocarbons (such as dichloromethane, dichloroethane, chloroform, chlorobenzene, and the like), ethers (such as diethyl ether, tetrahydrofuran, and the like), dimethyl sulfoxide, amides (such as N,N-dimethyl formamide, N,N-dimethyl acetamide, and the like), N-methyl pyrolidone, 1,3-dimethyl imidazolidinone, 3-methyl oxazolidinone, esters (such as ethyl acetate, butyl acetate, and the like), carbonates (such as diethyl carbonate, ethylene carbonate, propylene carbonate, and the like), ketones (such as acetone, 2-butanone, cyclohexanone, and the like), hydrocarbons (such as hexane, petroleum ether, benzene, toluene, and the like) and mixed solvents thereof. Preferable solvents are hydrocarbons, nitriles, halogenated hydrocarbons and ethers.

(b) Process of Mordanting with Dye

The semiconductor (including the semiconductor layer formed on the support) can be mordanted with the dye by dipping the semiconductor to which the bonding compound for mordanting has been bonded in a solution of the dye, or by coating the solution of the dye on the surface of the semiconductor (the surface to which the bonding compound for mordanting has been bonded). In the former case, immersion method, dipping method, roller method, air knife method, or the like, can be used. In the immersion method, adsorption of the dye may be carried out at room temperature, or may be carried out while heating the dye solution to reflux as described in JP-A No. 7-249790. As a coating method in the latter case, wire bar method, slide hopper method, extrusion method, curtain method, spin method, spray method, or the like, can be used.
Examples of a solvent used for preparing the dye solution preferably include alcohols (such as methanol, ethanol, t-butanol, benzylalcohol, and the like), nitriles (such as acetonitrile, propionitrile, 3-methoxypropionitrile, and the like), nitromethane, halogenated hydrocarbons (such as dichloromethane, dichloroethane, chloroform, chlorobenzene, and the like), ethers (such as diethyl ether, tetrahydrofuran, and the like), dimethyl sulfoxide, amides (such as N,N-dimethyl formamide, N,N-dimethyl acetamide, and the like), N-methyl pyrolidone, 1,3-dimethyl imidazolidinone, 3-methyl oxazolidinone, esters (such as ethyl acetate, butyl acetate, and the like), carbonates (such as diethyl carbonate, ethylene carbonate, propylene carbonate, and the like), ketones (such as acetone, 2-butanone, cyclohexanone, and the like), hydrocarbons (such as hexane, petroleum ether, benzene, toluene, and the like) and mixed solvents thereof.
A whole amount of the dye adsorbed by the semiconductor is preferably between 0.01 to 1mmol per 1g of the semiconductor. When using the semiconductor for photoelectric conversion of the present invention as a porous semiconductor layer of a photosensitive layer of a photoelectric converting device described later, an amount of the adsorbed dye is preferably 0.01 to 100 mmol per a unit area ($1m^2$) of an electrode of the photoelectric converting device. If the amount of the adsorbed dye is smaller than the above range, a sensitizing effect may be insufficient. While, if the amount of the adsorbed dye is larger than the above range, a part of the dye which has not been fixed to the surface of the semiconductor may float to lower the sensitizing effect. The amount of the adsorbed dye within the above range is preferable since it does not cause the above described problems and a sufficient sensitizing effect by the dye in the semiconductor can be obtained. In addition, when mordanting the surface of the semiconductor with the dye, it is preferable to add a colorless compound to the dye and make the compound and the dye interact with the semiconductor since it can reduce an interaction such as aggregation between the dyes. As the colorless compound, a compound having a surface-activating property and structure is effective. Examples of the colorless compound include a steroid compound having a carboxyl group (such as ketodeoxycholic acid) and sulfonate salts,

Dye which has not been fixed to the surface of the semiconductor is preferably removed by washing immediately after the mordanting step. The washing is preferably carried out using, for example, a wet type washing bath and an organic solvent, such as a polar solvent (such as acetonitrile) or an alcohol solvent. Further, after the mordanting with the dye, the surface of the semiconductor may be treated using amines. Preferable examples of amines include pyridine, 4-t-butylpyridine, polyvinylpyridine, and the like. These may be used as is if they are liquid, or may be dissolved in an organic solvent.

The semiconductor for photoelectric conversion of the present invention can be suitably used in a photoelectric converting device.

[Photoelectric Converting Device]

Fig. 1 shows an exemplary photoelectric converting device of the present invention. In the photoelectric converting device of Fig. 1, the semiconductor for photoelectric conversion of the present invention is used in a form of a porous semiconductor layer included in a photosensitive layer. The photoelectric converting device 10 includes a conductive layer 12, an undercoat layer 14, the photosensitive layer 16, a charge transfer layer 18 and a counter electrode conductive layer 20 which are sequentially laminated. The photosensitive layer 16 consists of a semiconductor layer 24 sensitized with a dye d, and a charge transfer material t. The semiconductor layer 24 is a porous layer formed of semiconductor particles s. Gaps are formed between the semiconductor particles s, and the charge transfer material t fills the gaps. The charge transfer material t consists of the same components as those of a material used in the charge transfer layer 18. A substrate 26 is disposed under the conductive layer 12, and a substrate 28 is disposed above the counter electrode conductive layer 20. The substrates 26 and 28 are provided in order to add strength to the photoelectric converting device, and need not be present. Components of respective layers may be diffused and mixed at interfaces between layers, such as an interface between the conductive layer 12 and the photosensitive layer 16, an interface between the photosensitive layer 16 and the charge transfer layer 18, and an interface between the charge transfer layer 18 and the counter electrode conductive layer 20. Light may enter the photoelectric converting device 10 from one side or both sides. The conductive layer 12 and the substrate 26 and/or the counter electrode conductive layer 20 and the substrate 28 at a side of incident light may be made of materials which transmit light.

Next, operation of the photoelectric converting device 10 with n-type semiconductor particles s is described.

Light entering the photoelectric converting device 10 reaches the photosensitive layer 16, and is absorbed by the dye d, and the like, to generate the dye d in an excited state. The excited dye d, and the like, pass high-energy electrons to conduction bands of the semiconductor particles s, and become oxidants. The electrons passed to the conduction bands reach the conductive layer 12 via a network of the semiconductor particles s. Therefore, the conductive layer 12 has a negative potential with respect to the counter electrode conductive layer 20. In an aspect wherein the photoelectric converting device 10 is utilized in a photo cell, when the photo cell is connected to an external circuit, the electrons in the conductive layer 12 reach the counter electrode conductive layer 20 while working in the external circuit. When the charge transfer material is an electrolyte, the electrons reduce the electrolyte component (such as $I^-$), and the generated reductants (such as $I_3^-$) reduce the oxidants of the dye d into the original form. By continuing to irradiate light, the series reactions are continuously caused and electricity can be obtained.

Materials usable in the respective layers and forming methods thereof are described in detail below. Hereinafter, a term "conductive support" refers to both the single conductive layer 12 and the conductive support formed of the conductive layer 12 and the optionally provided substrate 26, and a term "counter electrode" refers to both the single counter electrode conductive layer 20 and the counter electrode formed of the counter electrode conductive layer 20 and the optionally provided substrate 28.

(A) Conductive Support

The conductive support is formed of a single conductive layer or two layers including a conductive layer and a substrate. In the former case, the conductive layer is made of a material which can sufficiently maintain strength and sealing performance of the conductive layer, such as a metallic material (platinum, gold, silver, copper, zinc, titanium, aluminum, or the like, or an alloy containing any of these metals). In the latter case, a substrate having a conductive layer containing a conductive agent at a photosensitive layer side thereof can be used. Preferable examples of the conductive agent include a metal (such as platinum, gold, silver, copper, zinc, titanium, aluminum, indium, or the like, or an alloy containing any of these metals), carbon or an oxide of a conductive metal (such as indium-tin complex oxide, tin oxide doped with fluorine or antimony, or the like). A thickness of the conductive layer is preferably about 0.02 to 10μm.

The conductive support preferably has a surface resistance as low as possible. A range of the surface resistance is preferably 50 Ω / □ or less, and more preferably 20 Ω/□ or less.

When the conductive support side is exposed to light, it is preferable that the conductive support is substantially

transparent. "Substantially transparent" means that a light transmittance thereof is at least 10%, preferably 50% or more, and most preferably 80% or more.

The transparent conductive support is preferably formed of a transparent substrate, such as glass, plastic, or the like, provided on a surface thereof with a transparent conductive layer containing a conductive metal oxide formed by coating, vapor deposition, or the like, As the transparent conductive layer, tin dioxide doped with fluorine or antimony, or indium-tin oxide (ITO) is preferable. As the transparent substrate, a glass substrate such as soda glass which is advantageous in view of costs and strength, no-alkali glass which does not have a problem of alkali elution, or the like, or a transparent polymer film can be used. Examples of a material used in the transparent polymer film include tetraacetyl cellulose (TAC), polyethylene terephthalate (PET), polyethylene naphthalate (PEN), syndiotactic polystyrene (SPS), polyphenylene sulfide (PPS), polycarbonate (PC), polyarylate (PAr), polysulfon (PSF), polyester sulfon (PES), polyether imide (PEI), cyclopolyolefin, phenoxy bromide, and the like. In order to ensure a sufficient transparency of the conductive support, an amount of the conductive metal oxide coated on the glass or plastic support is preferably 0.01 to 100g/$m^2$.

A metal lead is preferably used in order to reduce a resistance of the conductive support. The metal lead is preferably made of platinum, gold, nickel, titanium, aluminum, copper, silver, or the like. The metal lead can be provided on the substrate by vapor deposition, sputtering, or the like, and a conductive layer formed of conductive tin oxide or an ITO film is preferably provided over the metal lead. A reduction in an amount of incident light by provision of the metal lead is preferably 10% or less, and more preferably 1% to 5%.

(B) Photosensitive Layer

The photosensitive layer includes the semiconductor for photoelectric conversion of the present invention. The photosensitive layer has a function of absorbing light and performing charge separation to generate electrons and holes. The semiconductor for photoelectric conversion of the present invention is a dye-sensitized semiconductor, in which absorption of light and generation of electrons and holes caused by the light absorption mainly occur at the dye, and the semiconductor receives and transmits the electrons (or holes). The semiconductor used in the present invention is preferably an n-type semiconductor in which conduction electrons become carriers and give an anode current.

Since the semiconductor materials and the mordanting with the sensitizing dye have been already described, a method for forming a semiconductor layer on the conductive support is described now.

The semiconductor layer is preferably a porous layer formed of semiconductor particles. The porous semiconductor layer can be formed by coating a coating solution containing the semiconductor particles on the conductive support. The coating solution may be a dispersion prepared by dispersing the semiconductor particles in a suitable dispersion medium, or a colloidal solution prepared by dissolving the semiconductor particles in a suitable solvent into a colloidal form. The semiconductor layer can be also formed using the above-described sol-gel process, or the like, besides coating the coating solution on the conductive support. Considering mass-production of the photoelectric converting device, physical properties of the semiconductor particle dispersion, flexibility of the conductive support, and the like, a wet-type film forming method is relatively advantageous. Typical wet-type film forming methods include coating, printing, electrolytic deposition and electrodeposition. Further, a film can also be formed by oxidizing a metal, deposition in liquid phase from a metal solution by ligand exchange or the like (LPD method), vapor deposition by sputtering or the like, CVD method, or SPD method in which a metal oxide is formed by spraying a pyrolizable metal oxide precursor on a heated substrate.

The semiconductor particle dispersion can be prepared by the sol-gel process as well as grinding in a mortar, dispersing while grinding with a mill, depositing particles in a solvent when the semiconductor is synthesized and using in that state, or the like.

Examples of the dispersion medium or the solvent for the colloid solution include water and various organic solvents such as methanol, ethanol, isopropyl alcohol, dichloromethane, acetone, acetonitrile, ethyl acetate, and the like. When the semiconductor particle dispersion is prepared, a polymer (such as polyethylene glycol), a surfactant, an acid, a chelating agent, or the like, may be used as a dispersion assistant as necessary. It is preferable to add polyethylene glycol since a viscosity of the dispersion can be adjusted by changing a molecular weight of polyethylene glycol in order to form a semiconductor layer which is not easy to separate and to control a porosity of the semiconductor layer.

Preferable coating methods include application-type coating methods such as roller coating, dip coating, and the like, metering-type coating methods such as air knife coating, blade coating, and the like, and methods in which application and metering can be carried out on the same portion such as wire bar coating disclosed in Japanese Patent Application Publication (JP-B) No. 58-4589, slide hopper coating, extrusion coating and curtain coating described in US Patent Nos. 2,681,294, 2,761,419, 2,761,791, and the like. In addition, spin coating and spray coating are also preferable as wide-use methods. Preferable wet-type printing methods include three major printing methods: letterpress printing, offset printing and gravure, as well as intaglio printing, rubber plate printing, screen process printing, and the

like. A preferable film forming method is selected among them depending on a viscosity of the coating solution and a wet thickness of the film.

The semiconductor layer may be a single layer or may have a multi-layer structure. For example, a plurality of layers may be formed by coating semiconductor particle dispersions containing semiconductor particles having different particle diameters respectively, or containing different types of semiconductor particles (or different binders, additives) respectively. Coating a plurality of layers (multilayer coating) is also effective when a film thickness is not sufficient with a single coating.

Generally, thicker the thickness of the semiconductor layer (which is the same as the thickness of the photosensitive layer), larger the amount of the dye per a unit projected area, and therefore, a light capture rate is increased. However, since diffusion lengths of the generated electrons are increased, a loss due to charge re-coupling becomes large. Therefore, a preferable thickness of the semiconductor layer is 0.1 to 100μm. When the photoelectric converting device is used in a photocell, the thickness of the semiconductor is preferably 1 to 30μm, and more preferably 2 to 25 μm. An amount of the semiconductor particles coated on the support is preferably 0.5 to 100g/$m^2$, and more preferably 3 to 50g/ $m^2$.

After the coating solution containing the semiconductor particles is coated on the conductive support, a heating treatment is preferably carried out in order to electronically contact the semiconductor particles one another and to increase strength of the coating film and adhesion between the film and the support, A range of a heating temperature for the heat treatment is preferably between 40°C and 700°C, and more preferably between 100°C and 600°C. A heating time for the heat treatment is between about 10 minutes to 10 hours. When a support having a low melting or softening point such as a polymer film is used, a high-temperature treatment is not preferable since it causes deterioration of the support. Further, from a viewpoint of costs, the temperature is preferably as low as possible (for example, 50°C to 350°C). A heat treatment at a low temperature is enabled by performing the heat treatment in the presence of small semiconductor particles of 5 nm or less, a mineral acid and/or a metal oxide precursor, or by irradiating with ultraviolet rays, infrared rays, microwave, or the like, or applying an electric field or ultrasonic wave. In order to remove unnecessary organic substances, and the like, simultaneously, heating, decompression, an oxygen plasma processing, washing with pure water, washing with a solvent, washing with a gas, and the like are preferably carried out in a suitable combination besides the above-described irradiation and application.

In order to increase surface areas of the semiconductor particles, purity in the neighborhood of the semiconductor particles and efficiency of electron injection from the dye to the semiconductor particles, chemical plating using, for example, an aqueous titanium tetrachloride solution or electrochemical plating using, for example, an aqueous titanium trichloride solution may be carried out after the heat treatment. Further, it is effective to adsorb an organic substance, other than the dye, having a low electronic conductivity on the surface of the particle for preventing a flow of a reverse current from the semiconductor particles to the charge transfer layer. The organic substance to be adsorbed preferably has a hydrophobic group.

The porous semiconductor layer preferably has a large surface area so that it can adsorb much dye. The surface area of the semiconductor layer is preferably 10 times or more of the projected area, and more preferably 100 times or more of the projected area, An upper limit of the surface area is not particularly limited, however, is usually about 1000 times.

By bonding the bonding compound for mordanting to at least the surface of the thus-formed semiconductor layer in the manner described above, and then making the dye interact with the bonding compound for mordanting in the manner described above, the semiconductor layer which is mordanted and sensitized with the dye can be formed.

(C) Charge Transfer Layer

The charge transfer layer is a layer containing the charge transfer material which has a function of replenishing electrons to oxidants of the dye generated by light absorption. Examples of typical charge transfer materials usable in the present invention include ion transfer materials such as a solution of redox-pair ions (electrolytic solution), a so-called gel electrolyte formed by impregnating a solution of a redox pair in a gel of a polymer matrix, a molten salt electrolyte containing redox-pair ions, and a solid electrolyte. In addition to the ion-related charge transfer materials, charge transfer materials to which carrier movement in a solid relates, such as electron transfer materials and hole transfer materials can also be used. These charge transfer materials can be used in combination.

Use of the above-mentioned molten salt electrolyte as the charge transfer material is preferable since both of a high photoelectric conversion efficiency and a high durability can be obtained. The molten salt electrolyte refers to an electrolyte which is liquid at room temperature, or an electrolyte which has a low melting point, and examples thereof include known electrolytes such as pyridinium salt, imidazolium salt, triazolium salt, and the like, described in, for example, WO95/18456, JP-A No. 8-259543, "Denki-Kagaku" (Electrochemistry), vol. 65, No. 11, p. 923 (1997), and the like. A molten salt electrolytes which become liquid at 100°C or less, particularly around room temperature, is preferable.

Preferably usable molten salt electrolytes include compounds represented by one of the following general formulae (Y-a), (Y-b) and (Y-c).

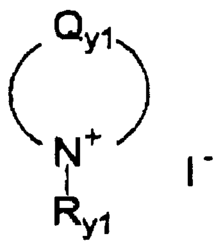

· · · (Y−a)

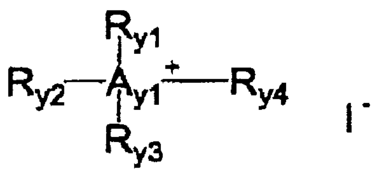

· · · (Y−b)

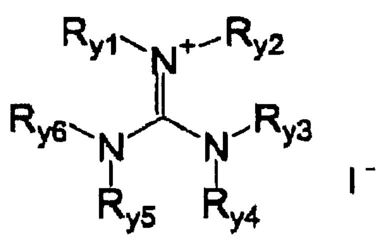

· · · (Y−c)

In general formula (Y-a), $Q_{y1}$ is an atomic group which may form a five- or six-membered ring aromatic cation together with the nitrogen atom. $Q_{y1}$ preferably consists of one or more kinds of atoms selected from a group consisting of a carbon atom, a hydrogen atom, a nitrogen atom, an oxygen atom and a sulfur atom. The five-membered ring which may be formed by $Q_{y1}$ is preferably a oxazole ring, a thiazole ring, an imidazole ring, a pyrazole ring, an isooxazole ring, a thiadiazole ring, an oxadiazole ring, a triazole ring, an indole ring or a pyrrole ring, more preferably an oxazole ring, a thiazole ring or an imidazole ring, and most preferably an oxazole ring or an imidazole ring. The six-membered ring which may be formed by $Q_{y1}$ is preferably a pyridine ring, a pyrimidine ring, a pyridazine ring, a pyrazine ring or a triazine ring, and more preferably a pyridine ring.

In general formula (Y-b), $A_{y1}$ is a nitrogen atom or a phosphorus atom.

In general formulae (Y-a), (Y-b) and (Y-c), each of $R_{y1}$ to $R_{y6}$ is a substituted or unsubstituted alkyl group (preferably having 1 to 24 carbon atoms, may be in a straight-chain form, a branched-chain form or a cyclic form, such as a methyl group, ethyl group, propyl group, isopropyl group, pentyl group, hexyl group, octyl group, 2-ethylhexyl group, t-octyl group, decyl group, dodecyl group, tetradecyl group, 2-hexyldecyl group, octadecyl group, cyclohexyl group, cyclopentyl group, or the like) or a substituted or unsubstituted alkenyl group (prefearbly having 2-24 carbon atoms, may be in a straight-chain form or a branched-chain form, such as a vinyl group, allyl group, or the like), more preferably is an alkyl group having 2 to 18 carbon atoms or an alkenyl group having 2 to 18 carbon atoms, and most preferably is an alkyl group having 2 to 6 carbon atoms.

Two or more of $R_{y1}$ to $R_{y4}$ in general formula (Y-b) may be bonded together to form a non-aromatic ring including $A_{y1}$, and two or more of $R_{y1}$ to $R_{y6}$ in general formula (Y-c) may be bonded together to form a ring structure.

In general formulae (Y-a), (Y-b) and (Y-c), $Q_{y1}$ and $R_{y1}$ to $R_{y6}$ may have substituents. Examples of preferable substituents include a halogen atom (such as F, Cl, Br, I, and the like), cyano group, alkoxy group (such as methoxy group, ethoxy group, methoxy-ethoxy group, methoxy-ethoxy-ethoxy group, and the like), aryloxy group (such as phenoxy group, and the like), alkylthio group (such as methylthio group, ethylthio group, and the like), alkoxycarbonyl group (such as ethoxycarbonyl group, and the like), carbonate group (such as ethoxycarbonyloxy group, and the like), acyl group (such as acetyl group, propionyl group, benzoyl group, and the like), sulfonyl group (such as methanesulfonyl

group, benzenesulfonyl group, and the like), acyloxy group (such acetoxy group, benzoyloxy group, and the like), sulfonyloxy group (such as methanesulfonyloxy group, toluenesulfonyloxy group, and the like), phosphonyl group (such as diethylphosphonyl group, and the like), amide group (such as acetylamino group, benzoylamino group, and the like), carbamoyl group (such as N,N-dimethylcarbamoyl group, and the like), alkyl group (such as methyl group, ethyl group, propyl group, isopropyl group, cyclopropyl group, butyl group, 2-carboxyethyl group, benzyl group, and the like), aryl group (such as phenyl group, toluyl group, and the like), heterocyclic group (such as pyridyl group, imidazolyl group, furanyl group, and the like), alkenyl group (such as vinyl group, 1-propenyl group, and the like), silyl group, silyloxy group, and the like.

The compound represented by general formula (Y-a), (Y-b) or (Y-c) may form a polymer through $Q_{y1}$, or $R_{y1}$ to $R_{y6}$.

The compounds represented by general formula (Y-a), (Y-b) and (Y-c) may be used singly or in combination of two or more of them as the charge transfer material, and may be used in combination with the molten salt in which the iodine anion is substituted by other anion. Preferable examples of an anion to be substituted with the iodine anion include a halide ion (such as $Cl^-$, $Br^-$, or the like), $SCN^-$, $BF_4^-$, $PF_6^-$, $ClO_4^-$, $(CF_3SO_2)_2N^-$, $(CF_3CF_2SO_2)_2N^-$, $CH_3SO_3^-$, $CF_3SO_3^-$, $CF_3COO^-$, $Ph_4B^-$, $(CF_3SO_2)_3C^-$, and the like, and more preferably include $SCN^-$, $CF_3SO_3^-$, $CF_3COO^-$, $(CF_3SO_2)_2N^-$, and $BF_4^-$. Further, other iodine salts such as LiI and alkali metal salts such as $CF_3COOLi$, $CF_3COONa$, LiSCN and NaSCN can also be added. An amount of an alkali metal salt to be added is preferably about 0.02 to 2% by mass, and more preferably 0.1 to 1% by mass.

Specific examples of the molten salt preferably used as the charge transfer material in the present invention are shown below, however, these are not intended to limit the molten salt usable in the present invention.

(Y1)

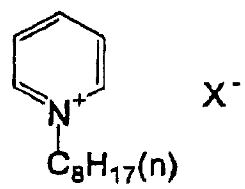

Y1-1 X=I
Y1-2 $X=BF_4$
Y1-3 $X=N(SO_2CF_3)_2$
Y1-4 $X=PF_6$

(Y2)

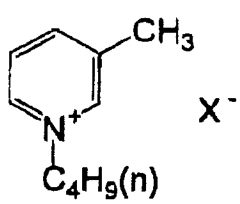

Y2-1 X=I
Y2-2 $X=BF_4$
Y2-3 $X=N(SO_2CF_3)_2$
Y2-4 $X=CF_3COO$
Y2-5 X=SCN
Y2-6 $X=CF_3SO_3$

(Y3)

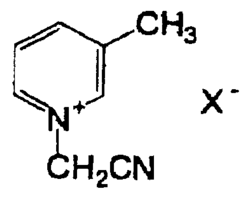

Y3-1 X=I
Y3-2 $X=BF_4$
Y3-3 $X=N(SO_2CF_3)_2$

(Y4)

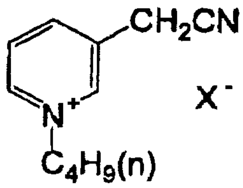

Y4-1 X=I
Y4-2 $X=BF_4$
Y4-3 $X=N(SO_2CF_3)_2$

(Y5)

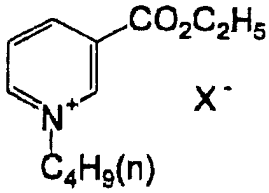

Y5-1 X=I
Y5-2 $X=BF_4$
Y5-3 $X=N(SO_2CF_3)_2$

(Y6)

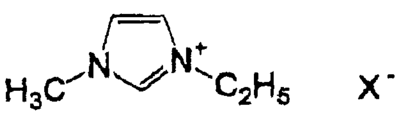

Y6-1 X=I
Y6-2 $X=BF_4$
Y6-3 $X=N(SO_2CF_3)_2$
Y6-4 X=Br
Y6-5 $X=CF_3COO$
Y6-6 X=SCN
Y6-7 $X=CF_3SO_3$

(Y7)

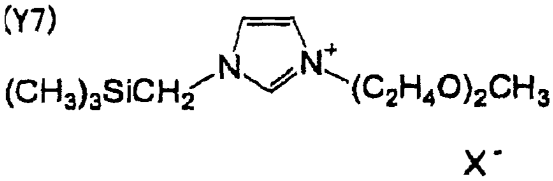

Y7-1 X=I
Y7-2 $X=BF_4$
Y7-3 $X=N(SO_2CF_3)_2$
Y7-4 $X=CF_3COO$
Y7-5 X=SCN

(Y8)

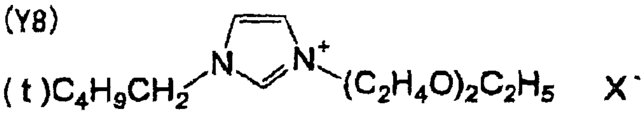

Y8-1 X=I
Y8-2 $X=BF_4$
Y8-3 $X=N(SO_2CF_3)_2$
Y8-4 $X=PF_6$
Y8-5 $X=CF_3COO$
Y8-6 X=SCN
Y8-7 $X=CF_3SO_3$

(Y9)

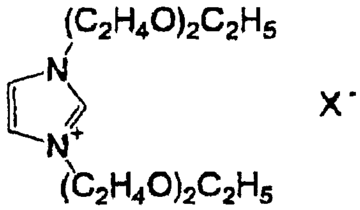

Y9-1 X=I
Y9-2 $X=BF_4$
Y9-3 $X=N(SO_2CF_3)_2$
Y9-4 $X=CF_3COO$
Y9-5 X=SCN
Y9-6 $X=CF_3SO_3$

(Y10)

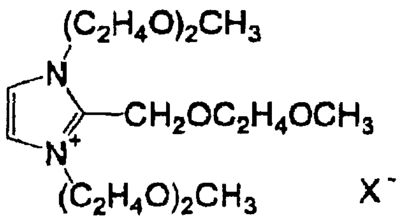

Y10-1 X=I
Y10-2 $X=BF_4$
Y10-3 $X=N(SO_2CF_3)_2$

(Y11)

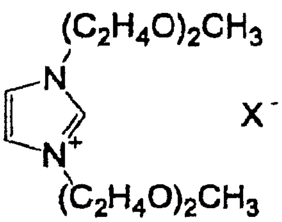

Y11-1 X=I
Y11-2 $X=BF_4$
Y11-3 $X=N(SO_2CF_3)_2$

(Y12)

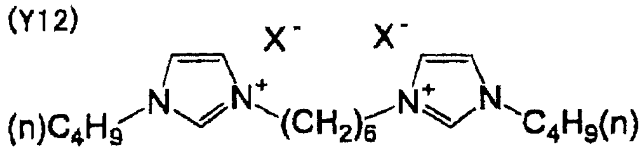

Y12-1 X=I
Y12-2 $X=BF_4$
Y12-3 $X=N(SO_2CF_3)_2$

(Y13)

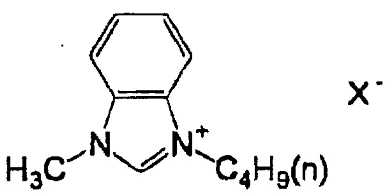

Y13-1 X=I
Y13-2 $X=BF_4$
Y13-3 $X=N(SO_2CF_3)_2$

(Y14)

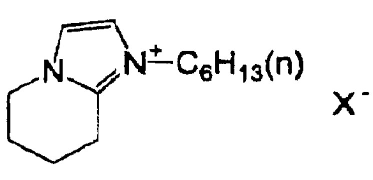

Y14-1 X=I
Y14-2 $X=BF_4$
Y14-3 $X=N(SO_2CF_3)_2$

(Y15)

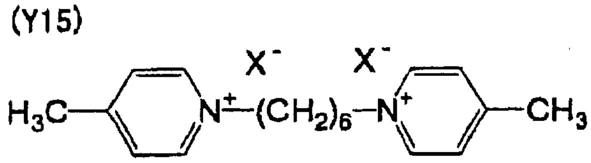

Y15-1 X=I
Y15-2 X=$BF_4$
Y15-3 X=$N(SO_2CF_3)_2$

(Y16)

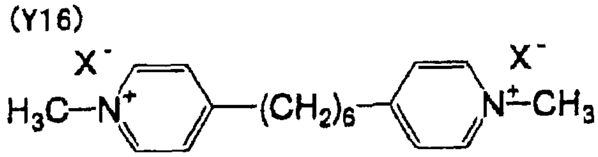

Y16-1 X=I
Y16-2 X=$BF_4$
Y16-3 X=$N(SO_2CF_3)_2$

(Y17)

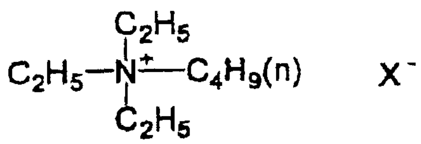

Y17-1 X=I
Y17-2 X=$BF_4$
Y17-3 X=$N(SO_2CF_3)_2$
Y17-4 X=$PF_6$

(Y18)

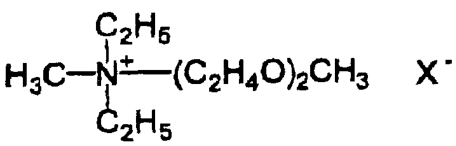

Y18-1 X=I
Y18-2 X=$BF_4$
Y18-3 X=$N(SO_2CF_3)_2$

(Y19)

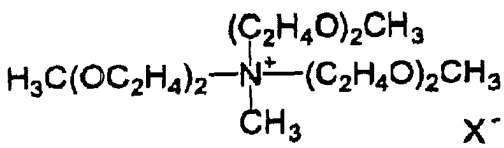

Y19-1 X=I
Y19-2 X=$BF_4$
Y19-3 X=$N(SO_2CF_3)_2$
Y19-4 X=$CF_3COO$
Y19-5 X=SCN
Y19-6 X=$CF_3SO_3$

(Y20)

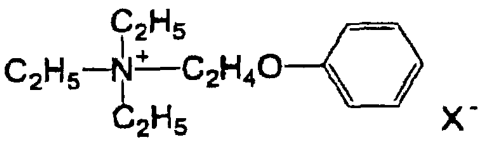

Y20-1 X=I
Y20-2 X=$BF_4$
Y20-3 X=$N(SO_2CF_3)_2$

(Y21)

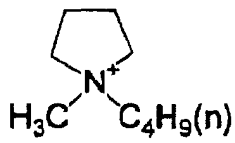

$X^-$

Y21-1 X=I
Y21-2 $X=BF_4$
Y21-3 $X=N(SO_2CF_3)_2$

(Y22)

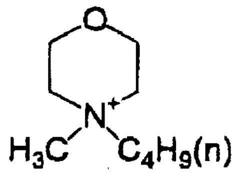

$X^-$

Y22-1 X=I
Y22-2 $X=BF_4$
Y22-3 $X=N(SO_2CF_3)_2$

(Y23)

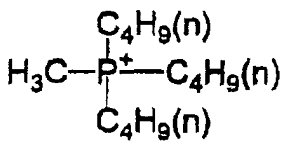

$X^-$

Y23-1 X=I
Y23-2 $X=BF_4$
Y23-3 $X=N(SO_2CF_3)_2$

(Y24)

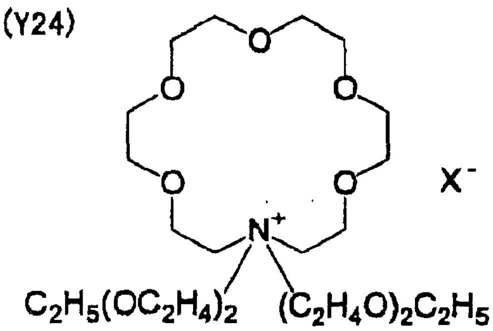

$X^-$

Y24-1 X=I
Y24-2 $X=BF_4$
Y24-3 $X=N(SO_2CF_3)_2$

(Y25)

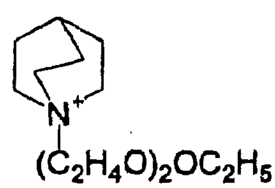

$X^-$

Y25-1 X=I
Y25-2 $X=BF_4$
Y25-3 $X=N(SO_2CF_3)_2$

(Y26)

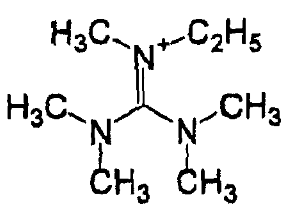

$X^-$

Y26-1 X=I
Y26-2 $X=BF_4$
Y26-3 $X=N(SO_2CF_3)_2$
Y26-4 $X=PF_6$

(Y27)

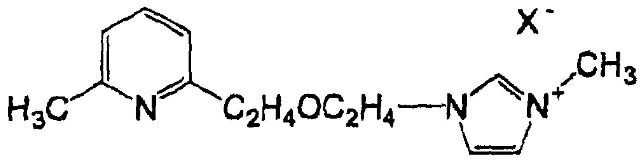

Y27-1 X=I
Y27-2 X=$N(SO_2CF_3)_2$
Y27-3 X=$BF_4$
Y27-4 X=$CF_3COO$
Y27-5 X=SCN
Y27-6 X=$CF_3SO_3$

(Y28)

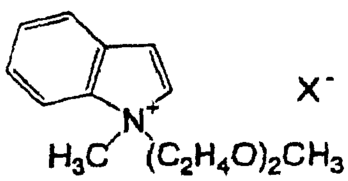

Y28-1 X=I
Y28-2 X=$BF_4$
Y28-3 X=$N(SO_2CF_3)_2$

(Y29)

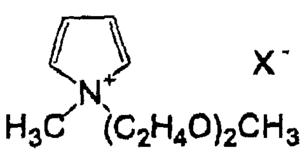

Y29-1 X=I
Y29-2 X=$BF_4$
Y29-3 X=$N(SO_2CF_3)_2$

The molten salt electrolyte is preferably in a molten state at room temperature and, preferably, no solvent is used. Solvents described later may be added, and a molten salt content in an electrolyte composition is preferably 50% by mass or more, particularly preferably 90% by mass or more, of the whole composition. Further, the salt preferably contains at least 50% by mass of iodine salt.

It is preferable to add iodine to the electrolyte composition, and in this case, the iodine content is preferably 0.1 to 20% by mass, more preferably 0.5 to 5% by mass of the whole electrolyte composition.

When an electrolytic solution is used as the charge transfer material, the electrolytic solution preferably consists of an electrolyte, a solvent and additives. Examples of the electrolyte usable in the present invention are a combination of $I_2$ and an iodide (e.g., a metal iodide such as LiI, NaI, KI, CsI, $CaI_2$, or the like, or an iodine salt of a quaternary ammonium compound such as tetraalkylammonium iodide, pyridinium iodide, imidazolium iodide, or the like); a combination of $Br_2$ and a bromide (e.g., a metal bromide such as LiBr, NaBr, KBr, CsBr, $CaBr_2$, or the like, or a bromine salt of a quaternary ammonium compound such as tetraalkylammonium bromide, pyridinium bromide, or the like); a metal complex such as ferrocyanic salt- ferricyanic salt, ferrocene-ferricinium ion, or the like; a sulfur compound such as sodium polysulfide, alkylthiol-alkyldisulfide, or the like; a viologen dye; hydroquinone-quinone; and the like, Among them, the combination of $I_2$ and LiI or an iodine salt of a quaternary ammonium compound, such as pyridinium iodide or imidazolium iodide, is preferable as the electrolyte. These electrolytes listed above may be used in combination.

The electrolyte concentration in the electrolytic solution is preferably between 0.1 M(mol/L) and 10 M(mol/L), and more preferably between 0.2 M(mol/L) and 4 M(mol/L). A preferable iodine concentration in the electrolytic solution when iodine is added to the electrolytic solution is between 0,01 M(mol/L) and 0.5 M(mol/L).

A solvent used in the electrolytic solution is desirably a compound having a low viscosity to increase ion mobility or having a high dielectric constant to increase an effective carrier concentration, and therefore can manifest an excellent ionic conductivity. Examples of such a solvent include carbonate compounds such as ethylene carbonate, propylene carbonate, and the like; heterocyclic compounds such as 3-methyl-2-oxazolidinone, and the like; ether compounds such as dioxane, diethylether, and the like; chain ethers such as ethyleneglycol dialkyl ether, propyleneglycol dialkyl ether, polyethyleneglycol dialkyl ether, polypropyleneglycol dialkyl ether, and the like; alcohols such as methanol, ethanol, ethyleneglycol monoalkyl ether, propylenglycol monoalkyl ether, polyethyleneglycol monoalkyl ether, polypropyleneglycol monoalkyl ether, and the like; polyvalent alcohols such as ethylene glycol, polypropylene glycol, polyethylene glycol, polypropylene glycol, glycerin, and the like; nitrile compounds such as acetonitrile, glutarodinitrile, methoxyacetonitrile, propionitrile, benzonitrile, and the like; aprotic polar substances such as dimethylsulfoxide, sulfolane, and the like; water, and the like, and these solvents can be also used in combination.

Further, in the present invention, it is preferable to add a basic compound such as tert-butylpyridine, 2-picoline, 2,6-lutidine, or the like, such as described in J. Am. Ceram. Soc., 80 (12) 3157-3171 (1997), to the molten salt electrolyte or the electrolytic solution described above. When the basic compound is added, a preferable concentration thereof ranges from 0.05 M(mol/L) to 2 M(mol/L).

A gel electrolyte usable as the charge transfer material can be produced by gelatinizing (solidifying) the molten salt electrolyte or the electrolytic solution described above using approaches such as adding a polymer, adding an oil gelatinizer, polymerization including polyfunctional monomers, crosslinking of polymers, and the like. When the gelatinization is carried out by adding a polymer, compounds described in "Polymer Electrolyte Reviews-1 and 2" (jointly edited by J. R. MacCallum and C. A. Vincent, ELSEVIER APPLIED SCIENCE) can be used, and particularly, polyacrylonitrile and polyvinylidene fluoride can be preferably used. When the gelatinization is carried out by adding an oil gelatinizer, compounds described in J. Chem Soc. Japan, Ind. Chem. Sec., 46,779 (1943), J. Am, Chem. Soc., 111, 5442 (1989), J. Chem. Soc., Chem. Commun., 1993, 390, Angew, Chem, Int. Ed. Engl., 35, 1949 (1996), Chem. Lett., 1996, 885, and J. Chm. Soc., Chem. Commun., 1997, 545 can be used, and a compound having an amide structure in a molecular structure thereof is preferable. An example of the gelatinization of an electrolytic solution which is applicable to the present invention is described in JP-A No. 11-185863, and an example of the gelatinization of a molten salt electrolyte which is applicable to the present invention is described in JP-A 2000-58140.

When the gelatinization of the electrolyte is carried out by crosslinking of polymers, it is desirable to use a polymer containing a cross-linkable reactive group and a crosslinking agent in combination. In this case, preferable examples of the cross-linkable reactive group include an amino group and a nitrogen-containing heterocyclic ring (such as pyridine ring, imidazole ring, thiazole ring, oxazole ring, triazole ring, morpholine ring, piperidine ring, piperazine ring, or the like), and a preferable crosslinking agent is a reagent having at least two functional groups which can make an electrophilic reaction against a nitrogen atom (such as alkyl halide, aralkyl halide, sulfonate, acid anhydride, acid chloride, isocyanate, $\alpha,\beta$-unsaturated sulfonyl group, $\alpha,\beta$-unsaturated carbonyl group, $\alpha,\beta$-unsaturated nitrile group, or the like). Crosslinking techniques described in JP-A Nos. 2000-17076 and 2000-86724 are also applicable.

In the present invention, an organic, inorganic or a combination of organic and inorganic solid hole transfer material can be used as the charge transfer material, instead of the ionic conductive electrolyte such as the molten salt. As the organic hole transfer material, aromatic amines shown in J. Hagen et al., Synthetic Metal 89 (1997) 215-220, Nature, Vol. 395, 8 Oct. 1998, p583-585, WO97/10617, JP-A Nos. 59-194393 and 5-234681, US Patent No. 4,923,774, JP-A No. 4-308688, US Patent No. 4,764,625, JP-A Nos. 3-269084, 4-129271, 4-175395, 4-264189, 4-290851, 4-364153, 5-25473, 5-239455, 5-320634, 6-1972, 7-138562, 7-252474 and 11-144773, and the like, and triphenylene derivatives described in JP-A Nos. 11-149821, 11-148067 and 11-176489, and the like, can be preferably used. Further, oligothiophene compounds described in Adv, Mater. 1997, 9, No. 7, p557, Angew. Chem. Int. Ed. Engl. 1995, 34, No 3, p303-307, JACS, Vol. 120, No. 4, 1998, p664-672, and the like, polypyrrole described in K. Murakoshi et al.,; Chem, Lett. 1997, p471, and conductive polymers such as polyacetylene and a derivative thereof, poly(p-phenylene) and a derivative thereof, poly(p-phenylenevinylene) and a derivative thereof, polythienylenevinylene and a derivative thereof, polythiophene and a derivative thereof, polyaniline and a derivative thereof, polytoluidine and a derivative thereof, and the like, described in "Handbook of Organic Conductive Molecules and Polymers Vol. 1, 2, 3, 4" (written by NALWA, published by WILEY) can be preferably used.

As described in Nature, Vol. 395, 8 Oct. 1998, p583-585, a compound containing a cation radical such as tris (4-bromophenyl)aminium hexachloroantimonate for controlling a dopant level, or a salt such as $Li[(CF_3SO_2)_2N]$ for controlling a potential at a surface of an oxide semiconductor (compensating for a space-charge layer) may be added to the hole transfer material.

As the inorganic hole transfer material, a p-type inorganic compound semiconductor can be used. The p-type inorganic compound semiconductor to this end preferably has a band gap of at least 2eV, and more preferably 2.5eV or more. Further, an ionization potential of the p-type inorganic compound semiconductor is required to be smaller than an ionization potential at a dye-adsorbing electrode as a condition for reducing holes of the dye. A preferable range of the ionization potential of the p-type inorganic compound semiconductor varies depending on the dye being used. Generally, the range of between 4.5eV and 5.5eV is preferable, and between 4.7eV and 5.3eV is more preferable. The p-type inorganic compound semiconductor is preferably a compound semiconductor containing a monovalent copper, and examples of the compound semiconductor containing a monovalent copper include CuI, CuSCN, $CuInSe_2$, $Cu(In,Ga)Se_2$, $CuGaSe_2$, $Cu_2O$, CUS, $CuGaS_2$, $CuInS_2$, $CuAlSe_2$, and the like. Among them, CuI and CuSCN are preferable, and CuI is most preferable. Other examples of the p-type inorganic compound semiconductor usable in the present invention include GaP, NiO, CoO, FeO, $Bi_2O_3$, $MoO_2$, $Cr_2O_3$, and the like.

In the photoelectric converting device of the present invention, the charge transfer material can be penetrated

through pores into the semiconductor layer simultaneously with the formation of the charge transfer layer. The charge transfer layer can be formed by, for example, injecting a liquid charge transfer material into the gap formed between the photosensitive layer and the counter electrode which have been pasted together prior to the injection of the liquid charge transfer material. The charge transfer layer can also be formed by, for example, coating the charge transfer material directly on the photosensitive layer (the counter electrode is provided thereafter). In the former method, the charge transfer material can be interposed between the photosensitive layer and the counter electrode using a normal pressure process utilizing capillary phenomenon by dipping or the like, or a vacuum process in which a gas at the gap is removed by reducing pressure below the normal pressure and replaced with the liquid. In the latter method, when the liquid charge transfer material is used, the counter electrode is provided before the charge transfer material is dried, and the liquid leakage at edge portions is prevented. Further, when the gel electrolyte is used as the charge transfer material, the gel electrolyte may be coated in a wet state and solidified by polymerization or the like. In this case, the counter electrode may be provided after the charge transfer material is dried and solidified. The electrolytic solution as well as the wet-type organic hole transfer material and the gel electrolyte can be provided in the same manner as described above with respect to the formation of the semiconductor and the mordanting with the dye.

When the solid electrolyte or the solid hole transfer material is used, the charge transfer layer can be formed using a dry film-forming process such as vacuum deposition method or CVD method, and the counter electrode can be provide thereafter. The organic hole transfer material can be introduced into the electrode using various approaches such as vacuum deposition, casting, coating, spin coating, dipping, electrolytic polymerization, photo-electrolytic polymerization, and the like. The inorganic solid compound can also be introduced in the electrode using various approaches such as casting, coating, spin coating, dipping, electrolytic deposition, electroless plating, and the like.

(D) Counter Electrode

The counter electrode may have a single layer structure formed of a conductive material, or may be structured with a counter electrode conductive layer and a support substrate. Examples of a conductive material to be used in the counter electrode conductive layer include metals (such as platinum, gold, silver, copper, aluminum, magnesium, indium, and the like), carbon, and conductive metal oxides (such as indium-tin complex oxide, tin oxide doped with fluorine, and the like). Among them, platinum, gold, silver, copper, aluminum, and magnesium can be preferably used as the counter electrode layer. Preferable examples of the support substrate of the counter electrode include glass and plastic, and the above-described conductive agent is coated or deposited on the support substrate. A thickness of the counter electrode conductive layer is not particularly limited, however, is preferably 3 nm to 10 μm. The counter electrode layer preferably has a surface resistance as low as possible. A range of the surface resistance is preferably 50 Ω /□ or less, and more preferably 20 Ω/□ or less.

In order to allow light to enter from the conductive support side, the counter electrode side, or both sides and to reach the photosensitive layer, at least one of the conductive support and the counter electrode needs to be substantially transparent, From a viewpoint of increasing a power generation efficiency, it is preferable to make the conductive support transparent and let the light enter from the conductive support side. In this case, the counter electrode preferably has a light-reflecting property. As the counter electrode, glass or plastic deposited with a metal or a conductive oxide, or a thin metal film can be used.

The counter electrode can be formed by coating, plating or depositing (PVD, CVD) a conductive material directly on the charge transfer layer, or pasting a conductive layer side of a substrate having the conductive layer onto the charge transfer layer. As is the case of the conductive support described above, a metal lead is preferably used in order to reduce a resistance of the counter electrode, particularly when the counter electrode is transparent. Preferable materials of the metal lead, a way to provide the metal lead and reduction of an amount of incident light due to provision of the metal lead are the same as those in the case of the conductive support.

(E) Other Layers

In order to prevent a short-circuit between the counter electrode and the conductive support, a thin film layer of dense semiconductor is preferably provided between the conductive support and the photosensitive layer in advance as an undercoat layer, and this is particularly effective when an electron transfer material or a hole transfer material is used in the charge transfer layer. Preferable materials of the undercoat layer include $TiO_2$, $SnO_2$, $Fe_2O_3$, $WO_3$, ZnO, $Nb_2O_5$, and a more preferable material is $TiO_2$. The undercoat layer can be provided using, for example, spray pyrolysis described in Electrochemi. Acta 40, 643-652 (1995), sputtering, or the like. A thickness of the undercoat layer is preferably 5 to 1000 nm, and more preferably 10 to 500 nm.

Further, functional layers such as a protective layer, an anti-reflection layer, and the like, may be provided at an outer surface of one of or both of the conductive support which acts as the electrode and the counter electrode, between the conductive layer and the substrate, or at the middle of the substrate. These functional layers can be

formed using a method such as coating, vapor deposition, pasting, or the like, depending on materials used in respective layers.

As described above, an internal structure of the photoelectric converting device of the present invention can take various forms depending on the purposes. Dividing the forms of the internal structure in two wide classes, one class allow light to enter from both sides, and the other class allow light to enter only from one side. Figs. 2 to 9 show exemplary internal structures of the photoelectric converting device which are preferably applicable to the present invention. Parts in Figs. 2 to 9 which are the same as those in Fig. 1 are designated by the same reference numerals used in Fig. 1, and explanations thereof are omitted, When the conductive layer 12 and the substrate 26 transmit light, they are designated as a conductive layer 12' and a substrate 26', and when the counter electrode conductive layer 20 and the substrate 28 transmit light, they are designated as a counter electrode conductive layer 20' and a substrate 28'.

In a photoelectric converting device 10a in Fig. 2, a photosensitive layer 16 and a charge transfer layer 18 are interposed between a transparent conductive layer 12' and a transparent counter electrode conductive layer 20'. In this structure, light enters from both sides.

In a photoelectric converting device 10b in Fig. 3, metal leads 30 are partially provided on a transparent substrate 26', on which a transparent conductive layer 12' is provided, and an undercoat layer 14, a photosensitive layer 16, a charge transfer layer 18 and a counter electrode conductive layer 20 are provided in this order, and further, a support substrate 28 is provided. In this structure, light enters from the transparent conductive layer 12' side.

In a photoelectric converting device 10c in Fig. 4, a conductive layer 12, an undercoat layer 14, a photosensitive layer 16, a charge transfer layer 18 and a transparent counter electrode conductive layer 20' are provided on a support substrate 26, and a transparent substrate 28' partially provided with metal leads 30 is disposed so that the surface thereof having the metal leads 30 faces inside. In this structure, light enters from the counter electrode conductive layer 20' side.

In a photoelectric converting device 10d in Fig. 5, metal leads 30 are partially provided on a transparent substrate 26', on which a transparent conductive layer 12' is provided, and an undercoat layer 14, a photosensitive layer 16, a charge transfer layer 18 and a transparent counter electrode conductive layer 20' are provide in this order, and further, a transparent substrate 28' partially provided with metal leads 30 is provided on the top. In this structure, light enters from both sides.

In a photoelectric converting device 10e in Fig. 6, a transparent conductive layer 12', an undercoat layer 14, a photosensitive layer 16, a charge transfer layer 18 and a counter electrode conductive layer 20 are provided on a transparent substrate 26', and further a support substrate 28 is provided on the top. In this structure, light enters from the conductive layer 12' side.

In a photoelectric converting device 10f in Fig. 7, a conductive layer 12, an undercoat layer 14, a photosensitive layer 16, a charge transfer layer 18 and a transparent counter electrode conductive layer 20' are provided on a support substrate 26, and further a transparent substrate 28' is provided on the top, In this structure, light enters from the counter electrode conductive layer 20' side.

In a photoelectric converting device 10g in Fig. 8, a transparent conductive layer 12', an undercoat layer 14, a photosensitive layer 16, a charge transfer layer 18 and a transparent counter electrode conductive layer 20' are provided on a transparent substrate 26', and further a transparent substrate 28' is provided on the top. In this structure, light enters from both sides.

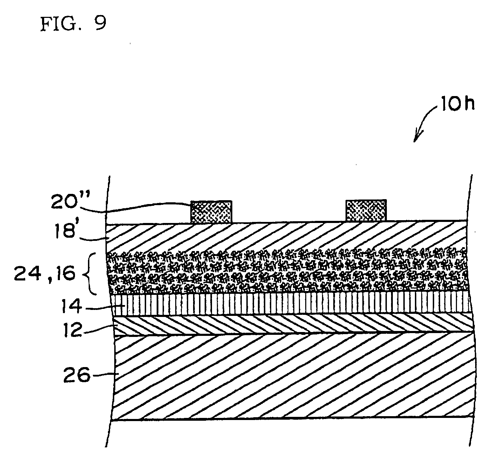

In a photoelectric converting device 10h in Fig. 9, a conductive layer 12, an undercoat layer 14, a photosensitive layer 16 and a solid charge transfer layer 18' are provided on a support substrate 26, and a partial counter electrode conductive layer 20" (or metal leads 30) is provided on the top. In this structure, light enters from the counter electrode 20" side.

The photoelectric converting device of the present invention is applicable to a photocell and an optical sensor. Photoelectric converting devices to be applied to a photocell and an optical sensor have structures similar to those of the photoelectric converting device described above. A photoelectric converting device produced for the purpose of doing electric work (power generation) while being connected to an external load is a photocell, and that produced for the purpose of sensing optical information is an optical sensor.

[Photocell]

A photocell of the present invention uses the photoelectric converting device of the present invention, and is adapted to make the photoelectric converting device work in an external load. The photocell having a charge transfer material mainly formed of an ion transfer material is particularly called a photo-electrochemical cell, and when its main purpose is power generation using solar light, it is called a solar cell. The photocell is preferably sealed by a polymer, an adhesive, or the like, at the sides for preventing deterioration of its components and volatilization of its contents. A known external circuit can be connected to the conductive support and the counter electrode via leads.

When the photoelectric converting device of the present invention is applied to a solar cell, an internal structure of the cell is fundamentally the same as that of the photoelectric converting device described above. Further, the solar cell of the present invention may take a modular structure which is fundamentally the same with a conventional solar cell module. The solar cell module generally has a structure in which a cell is provided on a support substrate made of a metal, ceramic, or the like, and is covered with a filling resin, a cover glass, or the like. The structure takes light at a side opposite to the support substrate. By using a transparent material such as a tempered glass as the support substrate and providing the cell on the transparent substrate, light can be taken in at the transparent support substrate side. Specifically, modular structures referred to as superstrate-type, substrate-type and potting-type, a substrate-integrated modular structure used in an amorphous silicon solar cell, and the like, are known. A structure of the solar cell of the present invention can be suitably selected from these modular structures depending on purposes of usage, service places and environments. Specifically, structures and aspects described in Japanese Patent Application No. 11-8457 are preferable.

EXAMPLES

Hereinafter, the present invention is described in more detail with reference to specific examples, however, the examples are not intended to limit the present invention.

[Example 1]

(A) Preparation of $TiO_2$ dispersion

15g of titanium dioxide particles (DEGUSSA P-25, available from Nippon Aerosil Corporated), 45g of water, 1g of a dispersant (TRITON X-100, available from Aldrich) and 30g of zirconia beads having 0.5mm diameter (available from Nikkato) were put in a 200ml stainless steel container Teflon-coated at the inside, and were dispersed for two hours at 1500rpm using a sand-grinder mill (manufactured by AIMEX Corporation). The zirconia beads were removed by filtration from the resulting dispersion. An average particle diameter of the titanium dioxide particles in the resulting dispersion was 2.5μm. The particle diameters were measured with MASTER SIZER manufactured by Malvern.

(B) Preparation of $TiO_2$ electrode

Using a glass rod, the above-described dispersion was applied to a conductive surface of a conductive glass plate having a tin oxide layer doped with fluorine (TCO GLASS-U, having a surface resistance of about 30 Ω/□, available from Asahi Glass Company, cut to a size of 20mm × 20mm). The amount of the semiconductor particles to be coated was 20g/$m^2$. At that time, adhesive tapes were placed on side portions (of 3mm width from the edge) of the conductive surface as spacers, and the glass plates were arranged in a line with the side portions having the adhesive tapes being side by side, in order to apply the dispersion on eight glass plates at a time. After the application, the adhesive tapes were removed and the glass plates were air-dried for one day at room temperature. Then, the glass plates were placed in an electric furnace (a muffle furnace FP-32 type available from Yamato Scientific Co., Ltd), calcined for 30 minutes at 450°C, and left for cooling to obtain $TiO_2$ electrodes.

(C) Mordanting with dye

The calcined electrodes which had been put out from the electric furnace and cooled were dipped in a solution of the bonding compound for mordanting (exemplary compound E-1) dissolved in methanol (concentration was 40 mmol/l) for 15 hours. Then, the $TiO_2$ electrodes were washed with acetonitrile and dried naturally. Then, the $TiO_2$ electrodes were dipped in a solution of the dye (exemplary compound D-1) dissolved in methanol (concentration was $3\times10^{-4}$ mol/l) for 15 hours. Then, the $TiO_2$ electrodes were washed with acetonitrile and dried naturally.

(D) Production of photocell

The dye-sensitized $TiO_2$ electrode substrates produced as described above and comparative electrode substrates (20 mm×20 mm) were respectively superposed on a platinum-deposited glass plate of the same size. Then, a electrolyte composition was penetrated between the glass plates using capillary phenomenon to introduce the electrolyte into the $TiO_2$ electrode to produce a photoelectric converting device having almost the same structure as that shown in Fig. 1. That is, the conductive support layer formed of the conductive glass (the transparent glass substrate 26' provided with the conductive layer 12' thereon), the dye-sensitized $TiO_2$ photosensitive layer 16, the charge transfer layer 18, the counter electrode conductive layer 20 formed of platinum and the transparent glass substrate 28' were

laminated in this order, and sealed with an epoxy-type sealing agent to produce a photocell.

[Examples 2 to 5]

Photocells were produced in the same manner as Example 1, except that the bonding compound for mordanting and the dye in Example 1 were respectively replaced with materials shown in Table 1.

[Comparative Example 1]

A photocell of Comparative Example 1 was produced in the same manner as Example 1, except that the bonding compound for mordanting in the third step of Example 1 was not used and a comparative dye shown below was used as the dye.

Comparative Dye

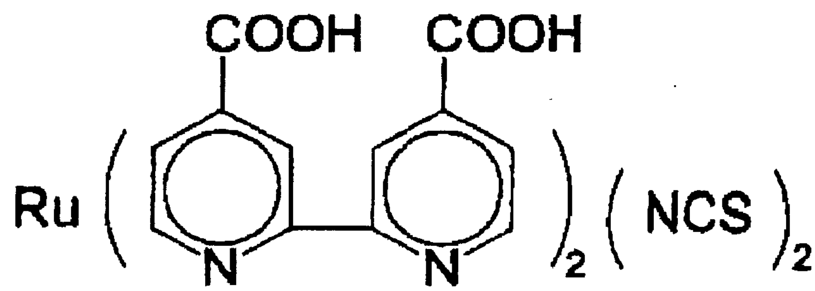

A photoelectric conversion efficiency was measured for each of the resulting photocells of Examples 1 to 5 and Comparative Example 1. Specifically, artificial solar light which did not contain ultraviolet was generated by filtering light from a 500W xenon lamp (produced by Ushio Inc.) with a AM1.5 filter (produced by Oriel) and a sharp cut filter (Kenko L-42). Intensity of the light was 86 $mW/cm^2$. Each of the produced photocells was exposed to the artificial solar light at a temperature of 25°C and a generated electricity was measured with a current-voltage-measuring device (Keithley SMU238-type). Open-circuit voltages ($V_{oc}$) of the respective photocells thus obtained are shown in Table 1 below.

Table 1

| | Bonding Compound for Mordanting | Dye | Open Circuit Voltage (V) |
|---|---|---|---|
| Example 1 | Exemplary Compound E-1 | Exemplary Compound D-1 | 0.90 |
| Example 2 | Exemplary Compound E-1 | Exemplary Compound D-4 | 0.85 |
| Example 3 | Exemplary Compound E-2 | Exemplary Compound D-1 | 0.92 |
| Example 4 | Exemplary Compound E-6 | Exemplary Compound D-2 | 0.87 |
| Example 5 | Exemplary Compound E-7 | Exemplary Compound D-7 | 0.81 |
| Com. Example 1 | - | Comparative Dye | 0.60 |

As can be seen from the results shown in Table 1, the photocells of the Examples have open circuit voltages higher than that of the photocell using the comparative dye 1.

[Example 6]

A photocell was produced in the same manner as Example 1, except that the step of mordanting with the dye was carried out as follows.

An electrode produced in the same manner as Example 1 (B) was dipped in a 10% solution of the bonding compound for mordanting (exemplary compound 2-1) dissolved in toluene for three days, washed with toluene, and dried under reduced pressure. Then, the electrode was dipped in a solution of the dye (exemplary compound R-1) dissolved in ethanol ($3 \times 10^{-4}$ mol/l) for 3 hours, washed with ethanol and dried naturally.

[Examples 7 to 13]

Photocells were produced in the same manner as Example 6, except that the bonding compound for mordanting, the dye and the electrolyte composition (a material having charge transfer property) were respectively replaced with materials shown in Table 2. However, if the viscosity of the electrolyte composition was high and it was hard to make the electrolyte composition penetrate using capillary phenomenon, the electrolyte composition was heated to 50°C and coated on the $TiO_2$ electrodes. Then, the electrodes were put under reduced pressure to let the electrolyte composition sufficiently penetrate and air in the electrodes be exhausted. Then, the $TiO_2$ electrodes were respectively superposed on a platinum-deposited glass plate to produce photocells.

[Comparative Examples 2 and 3]

Photocells were produced using materials shown in Table 2 in the same manner as Example 6, except that, in the step of mordanting with the dye of Example 6, the bonding compound for mordanting was not used and the $TiO_2$ conductive electrode was dipped in a solution of the dye (exemplary compound R-1) dissolved in ethanol ($3 \times 10^{-4}$ mol/l) for 3 hours, washed with ethanol and dried naturally.

A photoelectric conversion efficiency was measured for each of the resulting photocells of Examples 6 to 13 and Comparative Examples 2 and 3. Specifically, artificial solar light which did not contain ultraviolet was generated by filtering light from the 500W xenon lamp (produced by Ushio Inc.) with the AM1.5 filter (produced by Oriel) and the sharp cut filter (Kenko L-42), Intensity of the light was 100 mW/$cm^2$. Each of the produced photocells was exposed to the artificial solar light at a temperature of 25°C and a generated electricity was measured with the current-voltage-measuring device (Keithley SMU238-type). Open-circuit voltages ($V_{oc}$) of the respective photocells thus obtained are shown in Table 2 below.

Table 2

| Photocell No. | Bonding Compound for Mordanting | Dye | Charge Transfer Material (Electrolyte Composition) | Open Circuit Voltage (V) |
|---|---|---|---|---|
| Example 6 | 2-1 | R-1 · TBA Salt | A | 0.81 |
| Example 7 | 2-2 | R-1 · TBA Salt | A | 0.84 |
| Example 8 | 2-3 | R-1 · TBA Salt | A | 0.80 |
| Example 9 | 2-1 | R-1 · TBA Salt | B | 0.70 |
| Example 10 | 2-2 | R-1 · TBA Salt | B | 0.72 |
| Example 11 | 1-1 | R-1 | A | 0.82 |
| Example 12 | 1-6 | R-1 | A | 0.81 |
| Example 13 | 1-1 | R-1 | B | 0.70 |
| Com. Example 2 | - | R-1 · TBA Salt | A | 0.65 |
| Com. Example 3 | - | R-1 · TBA Salt | B | 0.56 |

A: iodine salt of 1-methyl-3-hexyl imidazolium: 0.5 mol/l
iodine: 0.05 mol/l
solvent: acetonitrile
B: (Y10-1)/(Y7-2)/iodine = 70/28/2 (% by mass)
TBA Salt: tetrabutylammonium salt

As can be seen from the results shown in Table 2, the photocells of the Examples have open circuit voltages higher than those of the Comparative Examples in both cases that the charge transfer material containing a solvent was used or the material which did not contain a solvent was used.

As described in detail above, the semiconductor for photoelectric conversion which exhibits a high open circuit voltage, as well as the photoelectric converting device which is excellent in photoelectric conversion characteristics and the photocell can be provided according to the present invention.

## Claims

**1.** A semiconductor for photoelectric conversion, the semiconductor comprising;

a compound bonded to the semiconductor at least at a surface of the semiconductor; and
a dye, which is fixed to the compound bonded to the semiconductor by one of interaction between a basic group and an acidic group and interaction between a cationic group and an anionic group formed by proton-dissociation of an acidic group.

**2.** A semiconductor for photoelectric conversion, the semiconductor comprising;

a compound bonded to the semiconductor at least at a surface of the semiconductor, the compound containing one of an acidic group and an anionic group formed by proton-dissociation of an acidic group; and
a dye, which is fixed to the compound bonded to the semiconductor to mordant the semiconductor, the dye containing at least one of a basic group and a cationic group.

**3.** A semiconductor for photoelectric conversion according to claim 2, wherein the compound having an acidic group or an anionic group formed by proton-dissociation of an acidic group is represented by the following general formula (1):

General Formula (1)

$$(Y^2)_n—A—Y^1\text{-}B$$

wherein, A is a carbonyl group, phosphonyl group, sulfonyl group, silyl group or borane; n is 1 if A is a carbonyl group or sulfonyl group, n is 2 if A is a phosphonyl group or borane, and n is 3 if A is a silyl group; $Y^1$ is a divalent group having a steric structure such that A and B cannot form bonds to the semiconductor at the same time; B is one of a carboxylic group, sulfonic group, phosphonic group, phosphoric group, silicic group, boric group, hydroxyl group, and respective hydrogen-dissociated forms thereof; $Y^2$ is an alkoxy group, aryloxy group, hydroxyl group, halogen atom or hydrogen atom; $Y^2$ is a leaving group which is entirely or partially eliminated when the compound represented by general formula (1) is bonded to the semiconductor.

**4.** A semiconductor for photoelectric conversion according to one of claims 2 and 3, wherein the compound containing one of an acidic group and an anionic group formed by proton-dissociation of an acidic group has substantially no absorbance in the visible light region.

**5.** A semiconductor for photoelectric conversion, the semiconductor comprising:

a structure represented by the following general formula (2) which is present at least at a surface of the semiconductor; and
a dye which is fixed to the structure to mordant the semiconductor, the dye containing at least one of a basic group and a cationic group:

General Formula (2)

$$(P_{SC}-O)_n-A-Y^1-B$$

wherein, $P_{sc}$ is a semiconductor, O is an oxygen atom, A is one of a carbonyl group, phosphonyl group, sulfonyl group, silyl group, and borane; n is 1 if A is a carbonyl group or sulfonyl group, n is 2 if A is a phosphonyl group or borane, and n is 3 if A is a silyl group; $Y^1$ is a divalent group; and B is one of a carboxylic group, sulfonic group, phosphonic group, phosphoric group, silicic group, boric group, hydroxyl group, and respective hydrogen-dissociated forms thereof.

**6.** A semiconductor for photoelectric conversion according to any one of claims 3 to 5, wherein $Y^1$ in general formulae (1) and (2) is represented by general formula (3) as follows:

General Formula (3)

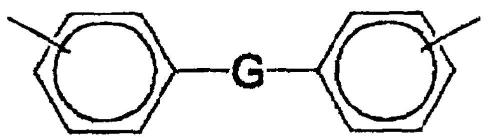

wherein, G is one of an alkyl group, oxygen atom, sulfon group, ester group, amide group, imide group and single bond.

**7.** A semiconductor for photoelectric conversion according to any one of claims 1 to 6, wherein the dye is a metal complex dye.

**8.** A semiconductor for photoelectric conversion according to claim 7, wherein the metal complex dye is a compound represented by general formula (4) as follows:

General Formula (4)

$$M(La)_{m1}(Lb)_{m2}(X)_{m3} \cdot CI$$

wherein, M is a metal atom, La is a bidentate or tridentate ligand represented by the following general formula (5), Lb is a bidentate or tridentate ligand represented by the following general formula (6), X is a monodentate or bidentate ligand, CI is a counter ion which is present if a counter ion is required to neutralize electric charge, ml is an integer from 1 to 3, m2 is an integer from 0 to 2, and m3 is an integer from 0 to 4, and general formula (5) is as follows:

General Formula (5)

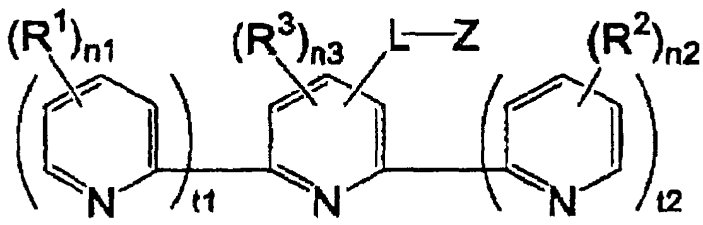

wherein, Z is a group containing a nitrogen cation; L is a linking group; each of $R^1$, $R^2$ and $R^3$ is a substituent; each of n1 and n2 is an integer from 1 to 4, n3 is an integer from 1 to 3, if n1 is larger than or equal to 2, one $R^1$ may be the same as and may be different from another $R^1$, and $R^1$s may be bonded to each other; if n2 is larger than or equal to 2, one $R^2$ may be the same as and may be different from another $R^2$, and $R^2$s may be bonded to each other; if n3 is larger than or equal to 2, one $R^3$ may be the same as and may be different from another $R^3$, and $R^3$s may be bonded to each other; each of t1 and t2 is an integer from 0 to 2, and a sum of t1 and t2 is at most 2; and if one of t1 or t2 is 0, substitution positions of L and $R^3$ may be on carbons adjacent to a nitrogen of a pyridine ring, and general formula (6) is as follows:

General Formula (6)

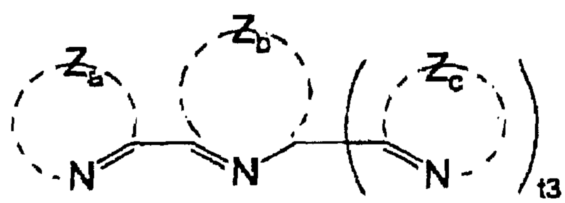

wherein, each of $Z_a$, $Z_b$ and $Z_c$ is a nonmetal atomic group which can form a five- or six-membered ring, and t3 is 0 or 1.

**9.** A semiconductor for photoelectric conversion according to claim 8, wherein, in general formula (4), M is a ruthenium atom.

**10.** A semiconductor for photoelectric conversion according to one of claims 8 and 9, wherein, in general formula (5), Z is represented by any one of the following general formulae (7) to (9):

General Formula (7)

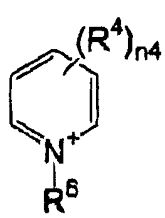

General Formula (8)

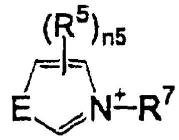

General Formula (9)

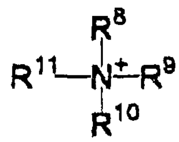

wherein, each of $R^4$ to $R^{11}$ is a substituent; n4 is an integer from 1 to 5, n5 is an integer from 1 to 3, if n4 is larger than or equal to 2, one $R^4$ may be the same as and may be different from another $R^4$, and $R^4$s may be bonded to each other; if n5 is larger than or equal to 2, one $R^5$ may be the same as and may be different from another $R^5$, and $R^5$s may be bonded to each other; E is one of an oxygen atom, sulfur atom and $-NR^{12}-$, and $R^{12}$ is a substituent; in general formula (7), any of $R^4$ and $R^6$ is bonded to L of general formula (5); in general formula (8), any of $R^5$, $R^7$ and $R^{12}$ is bonded to L of general formula (5); and, in general formula (9), any of $R^8$ to $R^{11}$ is bonded to L of general formula (5).

**11.** A semiconductor for photoelectric conversion according to any one of claims 1 to 10, wherein the semiconductor is titanium oxide.

**12.** A semiconductor for photoelectric conversion, the semiconductor comprising:

a compound bonded to the semiconductor at least at a surface of the semiconductor, the compound being one of a basic compound and a cationic compound; and
a dye having an acidic group or an anionic group formed by proton-dissociation of an acidic group is made to interact with the compound bonded to the surface to mordant the semiconductor.

**13.** A semiconductor for photoelectric conversion according to claim 12, wherein the compound is one of a compound represented by the following general formula (10) and a compound represented by the following general formula (11), the dye is a dye represented by the following general formula (12), and the general formulae (10) and (11) are as follows:

General Formula (10)

$$Z^1 \left[ (B^1)_{p1} - M^1 - (X^1)_{n1} \right]_{m^1}$$

General Formula (11)

$$Z^2 \left[ (B^2)_{p2} - M^2 - (X^2)_{n2} \right]_{m^2} \cdot (A)_q$$

wherein, $Z^1$ is a basic substituent having a conjugate acid's pKa from 3 to 20; $Z^2$ is an atomic group having a cation; each of $B^1$ and $B^2$ is a divalent linking group; each of $p^1$ and $p^2$ is 0 or 1; if $p^1$ is 0, $Z^1$ is directly bonded to $M^1$, if $p^2$ is 0, $Z^2$ is directly bonded to $M^2$; each of $M^1$ and $M^2$ is Si, Ti, Al, Ge or Sn; each of $X^1$ and $X^2$ is one of an alkoxy group, aryloxy group, hydroxyl group, halogen atom and hydrogen atom, and is entirely or partially eliminated when the at least one compound is bonded to the semiconductor; each of $m^1$ and $m^2$ is an integer from 1 to 3; $n^1$ is a number of $X^1$ which can be coordinated to $M^1$; $n^2$ is a number of $X^2$ which can be coordinated to $M^2$; if $m^1$ is larger than or equal to 2, one combination of $B^1$, $M^1$, $X^1$, $p^1$ and $n^1$ may be the same as and may be different from another combination thereof; if $m^2$ is larger than or equal to 2, one combination of $B^2$, $M^2$, $X^2$, $p^2$ and $n^2$ may be the same as and may be different from another combination thereof; A is an anion; and q is a number such that a cationic charge of $Z^2$ and a total of anionic charge of every A are equal, and general formula (12) is as follows:

General Formula (12)

$$\text{Dye}—(Y)_r$$

wherein, Dye is a dye residue, Y is one of the acidic group and the anionic group formed by proton-dissociation of an acidic group, and r is an integer from 1 to 6.

**14.** A semiconductor for photoelectric conversion, the semiconductor comprising:

a structure represented by at least one of the following general formula (13), (14) which is present at least at a surface of the semiconductor; and

a dye which is made to interact with the structure to mordant the semiconductor, the dye comprising at least one of an acidic group and an anionic group formed by proton-dissociation of an acidic group:

General Formula (13)

$$\left[(P_{sc}—O)_{n1}—M^1—(B^1)_{p1}\right]_{m1}—Z^1$$

General Formula (14)

$$\left[(P_{sc}—O)_{n2}—M^2—(B^2)_{p2}\right]_{m2}—Z^2\cdot(A)_q$$

wherein, $P_{sc}$ is a semiconductor; O is an oxygen atom; $Z^1$ is a basic substituent having a conjugate acid's pKa from 3 to 20; $Z^2$ is an atomic group having a cation; each of $B^1$ and $B^2$ is a divalent bonding group; each of $p^1$ and $p^2$ is 0 or 1; if $p^1$ is 0, $Z^1$ is directly bonded to $M^1$, and if $p^2$ iS 0, $Z^2$ is directly bonded to $M^2$; each of $M^1$ and $M^2$ is Si, Ti, Al, Ge or Sn; each of $m^1$ and $m^2$ is an integer from 1 to 3; if $m^1$ is 2 or 3, one combination of $B^1$, $M^1$ and $n^1$ may be the same as and may be different from another combination thereof; if $m^2$ is 2 or 3, one combination of $B^2$, $M^2$ and $n^2$ may be the same as and may be different from another combination thereof; A is an anion; and q is a number such that a cationic charge of $Z^2$ and a total of anionic charge of every A are equal.

**15.** A semiconductor for photoelectric conversion according to any one of claims 12 to 14, wherein the semiconductor contains at least a metal chalcogenide.

**16.** A semiconductor for photoelectric conversion according to any one of claims 12 to 15, wherein the dye is one of a metal complex dye and a methine dye.

**17.** A semiconductor for photoelectric conversion according to any one of claims 1 to 16, wherein the semiconductor is a porous semiconductor film comprising semiconductor particles formed on a support.

**18.** A photoelectric converting device comprising a pair of electrodes and, between the pair of electrodes, a photosensitive layer and a charge transfer layer, the photosensitive layer comprising the semiconductor for photoelectric conversion according to any one of claims 1 to 17.

**19.** A photocell comprising the photoelectric converting device according to claim 18.

FIG. 1

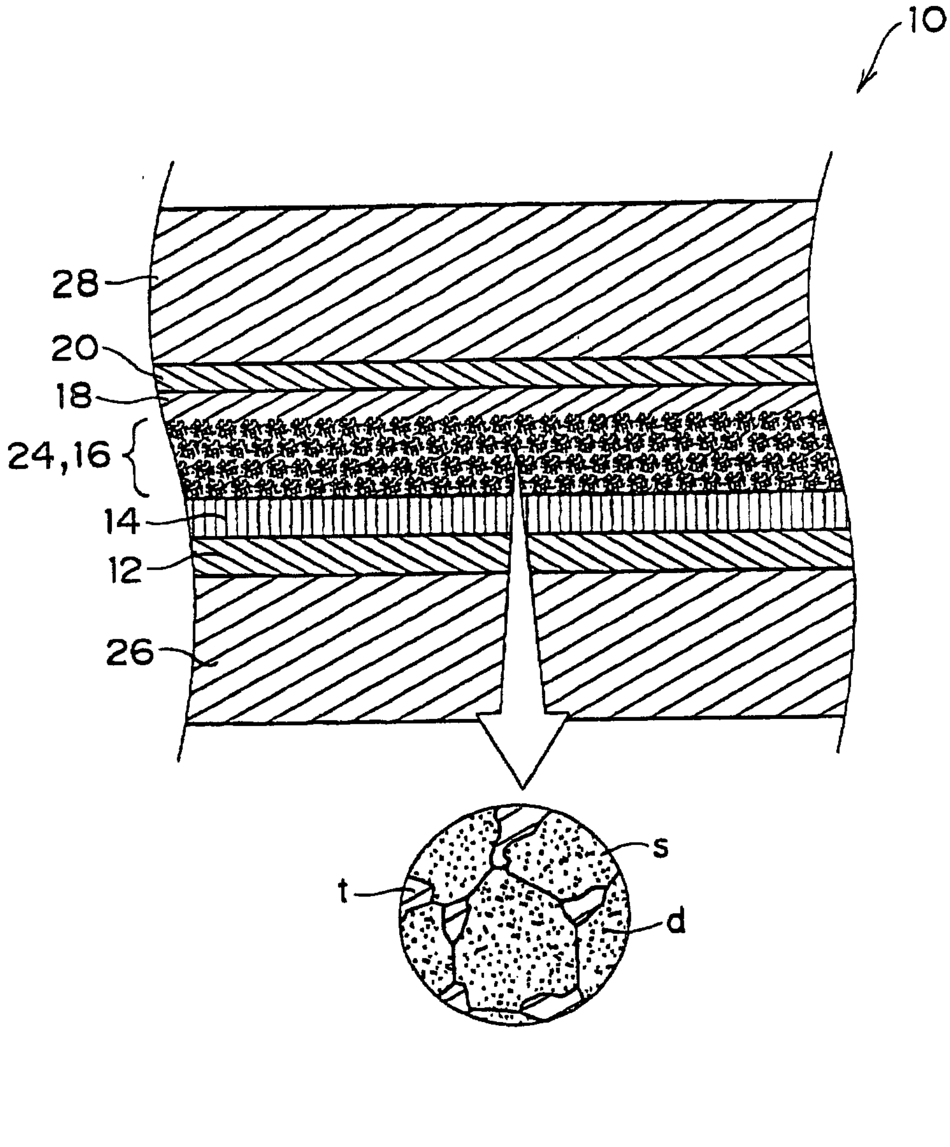

FIG. 2

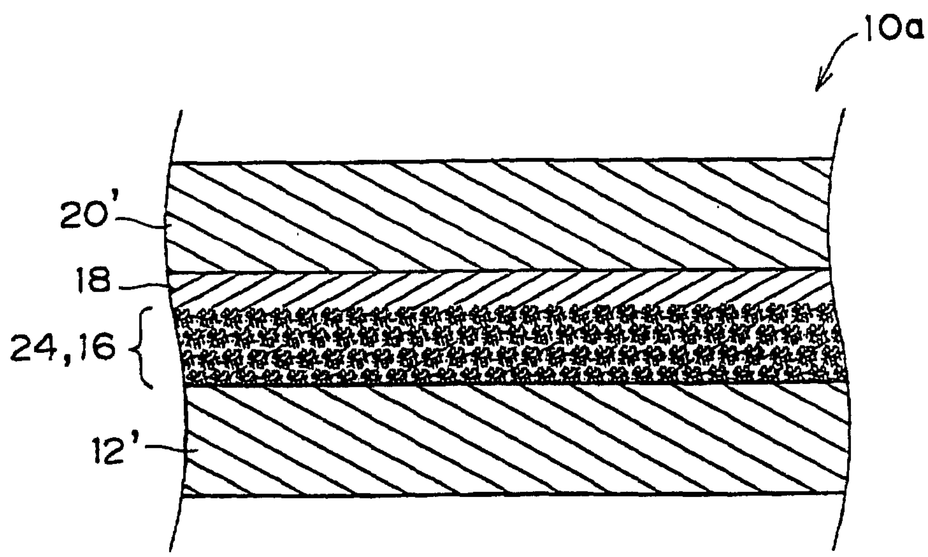

FIG. 3

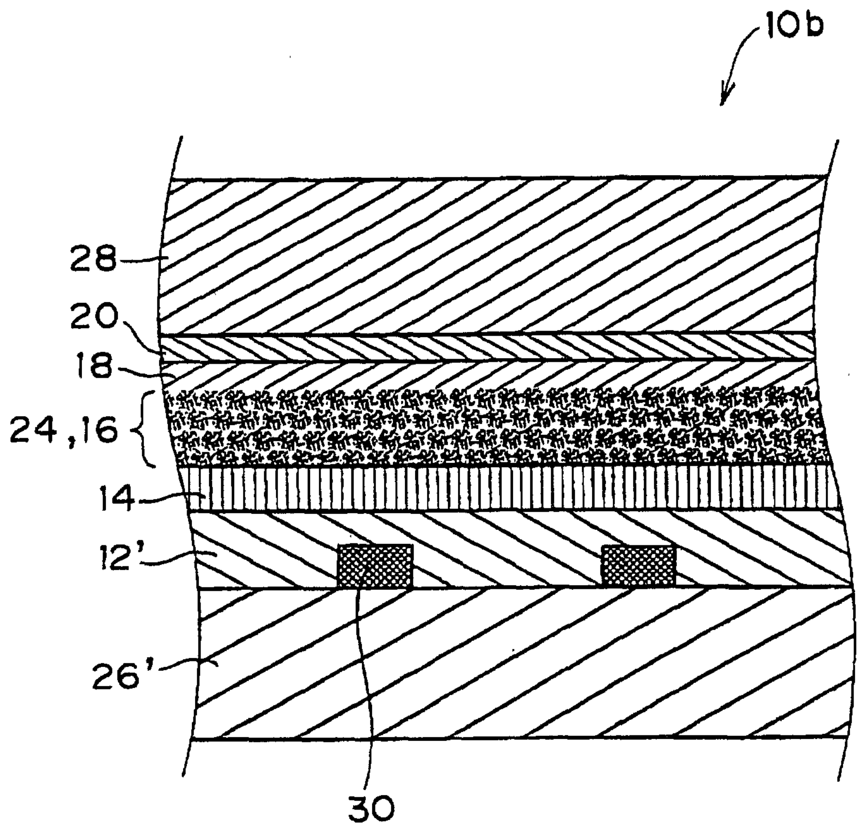

FIG. 4

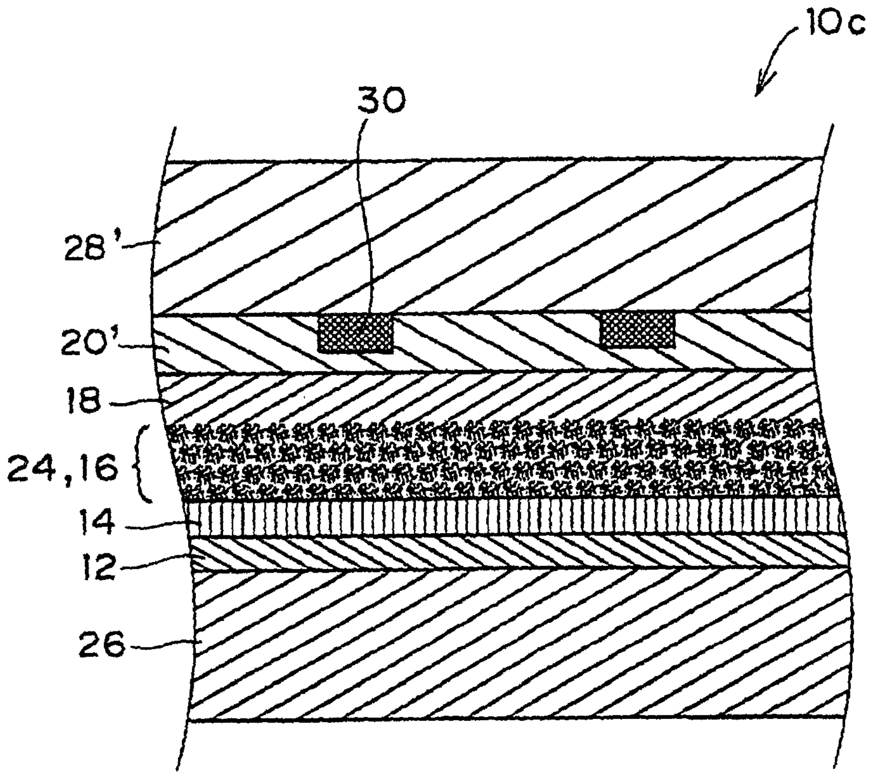

FIG. 5

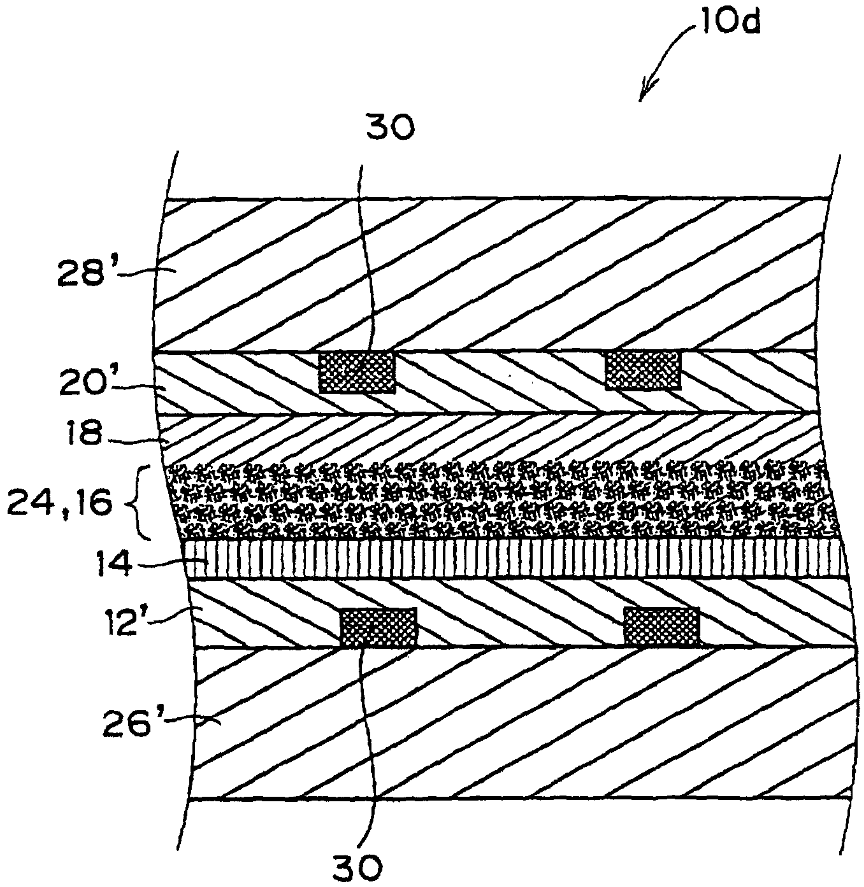

FIG. 6

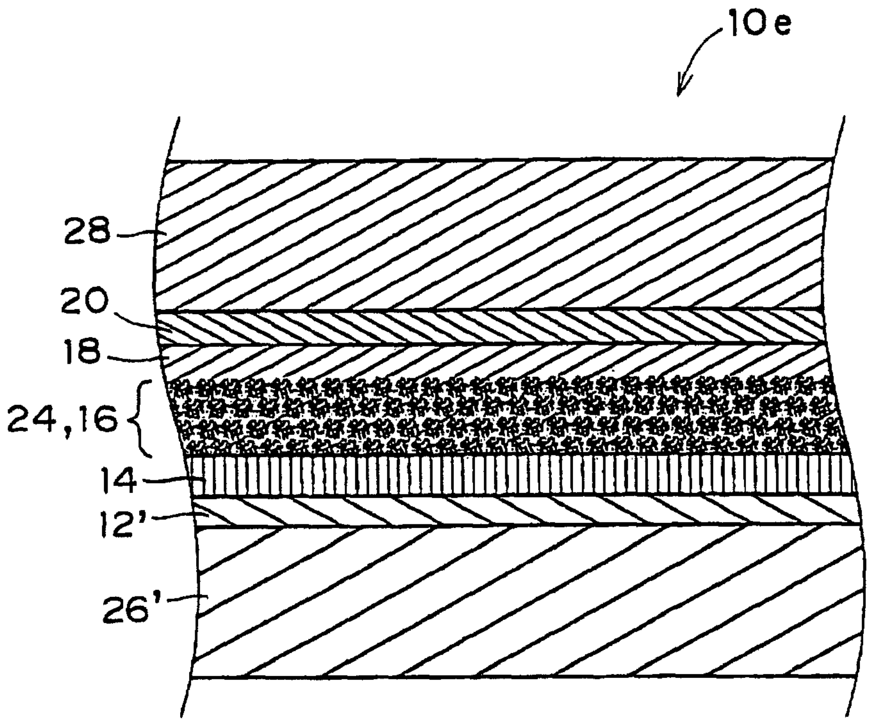

FIG. 7

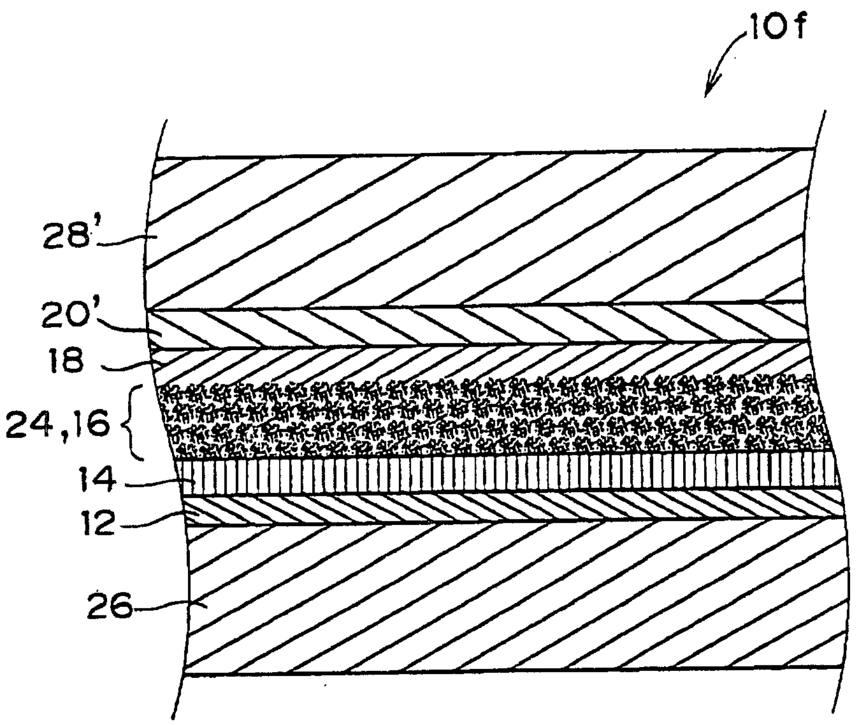

FIG. 8

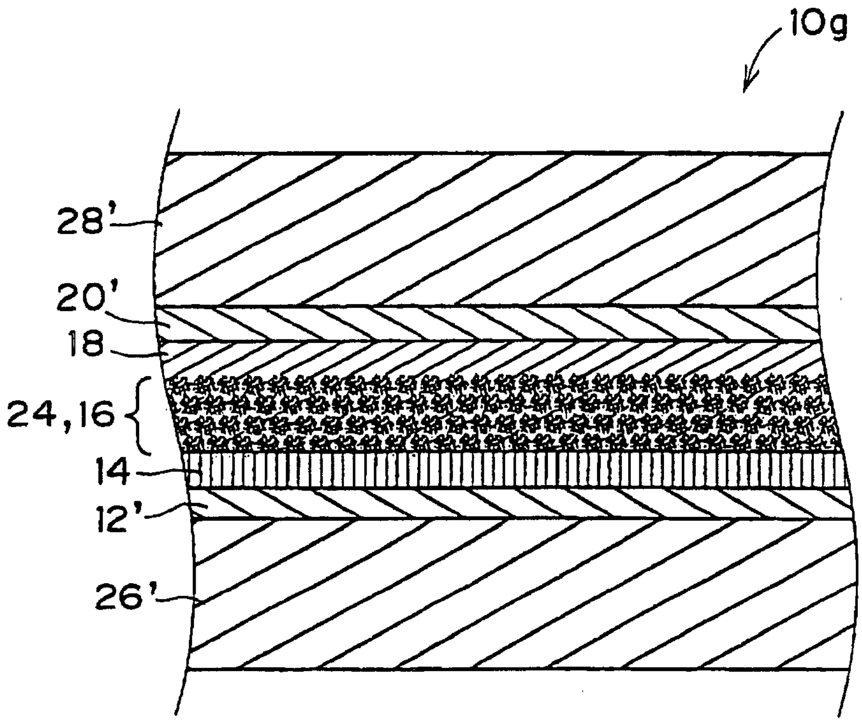

FIG. 9